# EUROPEAN PATENT APPLICATION

(11) **EP 4 604 186 A1**
(43) Date of publication of application: **20.08.2025**
(21) Application number: 23877396.4
(22) Date of filing: 11.04.2023
(51) Int. Cl.: H01L 33/50, H01L 33/62, H01L 33/38, H01L 33/32, H01L 33/54, H01L 33/56

(54) **LIGHT-EMITTING DEVICE, LIGHT-EMITTING PACKAGE, AND APPARATUS COMPRISING SAME**

(30) Priority: 14.10.2022 US 202263416307 P; 18.01.2023 US 202318155902
(71) Applicant: Seoul Semiconductor Co., Ltd., Gyeonggi-do 15429 (KR)
(72) Inventor: KO, Miso, Ansan-Si Gyeonggi-do 15429 (KR); LEE, Myung Hee, Ansan-Si Gyeonggi-do 15429 (KR); LEE, Chunghoon, Ansan-Si Gyeonggi-do 15429 (KR)
(74) Representative: Stolmár & Partner Patentanwälte PartG mbB
(86) International application number: PCT/KR2023/004868
(87) International publication number: WO 2024/080464

(57) **Abstract**

Disclosed are a light emitting device, a light emitting package and a backlight unit including the same. A light emitting device emitting light in a blue wavelength band may include a light generation layer and an electrode. The light generation layer may include a first semiconductor layer, a second semiconductor layer, and an active layer formed between the first semiconductor layer and the second semiconductor layer. The electrode may include a first electrode electrically connected to the first semiconductor layer and a second electrode electrically connected to the second semiconductor layer. Here, for the light emitting device, the quantity of light in a desaturation band may be lower than the quantity of light in other wavelength bands.

## Description

### [Technical Field]

The present invention relates to a light emitting device, a light emitting package, a backlight unit including the same, a display apparatus including the same, and a lighting apparatus including the same.

### [Background Art]

A light emitting diode is an inorganic semiconductor device that emits light generated through recombination of electrons and holes. In recent years, the light emitting diode is used in various fields, such as display apparatuses, vehicle lamps, and general lighting.

Light emitting diodes have advantages of longer lifespan, lower power consumption, and faster response speed than typical light sources. With such advantages, light emitting diodes are rapidly replacing existing light sources.

Depending on color saturation of light emitted from a lighting lamp, the color saturation of an illuminated object can vary. The higher the color saturation of the object, the clearer the object appears, whereas the lower the color saturation thereof, the blurrier the object appears.

That is, the color of the object can be expressed more accurately with increasing saturation of light emitted from the lighting lamp. Accordingly, it is necessary to improve the saturation of the lighting to which a light emitting diode is applied in order to make the object look more vivid.

The above information disclosed in this background art is only for understanding of the background art of the invention concepts, and, therefore, it may contain information that does not constitute prior art.

### [Disclosure]

### [Technical Problem]

Embodiments of the present invention provide a light emitting device capable of improving saturation of light, a light emitting package, and a backlight unit including the same.

### [Technical Solution]

In accordance with one embodiment of the present invention, a light emitting device emitting light in a blue wavelength band is provided. The light emitting device may include a light generation layer and an electrode. The light generation layer may include a first semiconductor layer, a second semiconductor layer, and an active layer formed between the first semiconductor layer and the second semiconductor layer. The electrode may include a first electrode electrically connected to the first semiconductor layer and a second electrode electrically connected to the second semiconductor layer. Here, for the light emitting device, the quantity of light in a desaturation band may be lower than the quantity of light in other wavelength bands. That is, the quantity of light in a saturation enhancement band may be higher than the quantity of light in other wavelength bands.

The desaturation band may be in the wavelength band of 400 nm to less than 455 nm.

The saturation enhancement band may be in the wavelength band of 455 nm or more.

The light may have a peak wavelength of 450 nm to 460 nm.

The active layer may be formed of a nitride-based material containing indium.

The active layer may have an indium content of 14% or more.

The active layer may be composed of InₓGa₍₁₋ₓ₎N, where x is greater than or equal to 0.14.

The light emitting device may further include a filter blocking or absorbing light in the desaturation band. Here, at least one of the first electrode and the second electrode may be formed on one surface of the light generation layer. The filter may cover at least part of the one surface of the light generation layer on which the electrode is not formed.

The filter may be formed of an insulating material. The insulating material for the filter may include at least one selected from among SiO₂, TiO₂, Nb₂O₅, MgO₂, Al₂O₃, ZrN, ZrO₂, and AlN.

The filter may be a distributed Bragg reflector.

The filter may further cover at least part of a side surface of the light emitting device.

In accordance with another embodiment of the present invention, a light emitting package including a support substrate, a light emitting device, and a molding portion is provided. The light emitting device may be disposed on the support substrate to be electrically connected to the support substrate. The molding portion may be formed on the support substrate to cover the light emitting device and may be formed of a light transmissive material. The light emitting device may include a first light emitting device including a light generation layer emitting light in a blue wavelength band and an electrode. The light generation layer may include a first semiconductor layer, a second semiconductor layer, and an active layer formed between the first semiconductor layer and the second semiconductor layer. The electrode may include a first electrode electrically connected to the first semiconductor layer and a second electrode electrically connected to the second semiconductor layer. The first light emitting device may include a first light emitting surface, a second light emitting surface, and a third light emitting surface, through which the light is emitted. The second light emitting surface may be a plane facing a mounting surface of the support substrate on which the light emitting device is mounted, the first light emitting surface may be a plane opposite to the second light emitting surface, and the third light emitting surface may be a side surface connecting the first light emitting surface to the second light emitting surface. The first light emitting device may emit a smaller quantity of light in a desaturation band than in other wavelength bands and the quantity of light in a saturation enhancement band may be higher than in other wavelength bands.

The desaturation band may be in the range of 400 nm to less than 455 nm.

The saturation enhancement band may be in the range of 455 nm or more.

The light emitted from the first light emitting device may have a peak wavelength of 450 nm to 460 nm.

The active layer may be formed of a nitride-based material containing indium.

The active layer may have an indium content of 14% or more.

The active layer may be composed of InₓGa₍₁₋ₓ₎N, wherein x is greater than or equal to 0.14

The light emitting package may further include a filter blocking or absorbing light in the desaturation band. The filter may cover the first light emitting surface of the first light emitting device.

The filter may be formed of an insulating material. The insulating material for the filter may include at least one selected from among SiO₂, TiO₂, Nb₂O₅, MgO₂, Al₂O₃, ZrN, ZrO₂, and AlN.

The filter may be a distributed Bragg reflector.

The filter may include a transparent resin and a light absorptive material dispersed in the transparent resin.

The light absorptive material may include at least one selected from among Ca, C, SiO₂, and TiO₂.

According to one embodiment, the first electrode and the second electrode of the first light emitting device may be disposed between the light generation layer and the support substrate.

The filter may include a first filter covering the first light emitting surface and a second filter covering at least part of the second light emitting surface on which the electrode is not formed.

According to another embodiment, at least one of the first electrode and the second electrode of the first light emitting device may be formed on one surface of the light generation layer. The one surface of the light generation layer may be a plane facing the first light emitting surface.

The filter may cover a portion of the first light emitting surface on which the electrode is not formed.

The filter may cover at least part of the third light emitting surface of the first light emitting device.

The molding portion may further include a wavelength conversion material.

The wavelength conversion material may include a material emitting green light excited by light emitted from the first light emitting device and a material emitting red light excited by light emitted from the first light emitting device.

The light emitting device may further include a second light emitting device and a third light emitting device. The second light emitting device may emit light in a green wavelength band and the third light emitting device may emit light in a red wavelength band.

The light emitting package may further include a reflective portion covering an upper surface of the molding portion.

According to one embodiment, the support substrate may be a circuit board.

According to another embodiment, the support substrate may be a housing having a cavity open at an upper surface thereof. The light emitting device may be mounted in the cavity of the housing.

A spectral area of light in the desaturation band among light emitted from the light emitting package may be less than 50% of a spectral area of light in an entire wavelength band. That is, the spectral area of light in the wavelength band excluding the desaturation band may be 50% or more of the entire spectral area and the spectral area of light in the saturation enhancement band (455 nm or more) among light emitted from the light emitting package may be 50% or more of a spectral area of light in the wavelength band of 400 nm to 500 nm.

Furthermore, the spectral area of light in the desaturation band among light emitted from the light emitting package may be less than 35% of the spectral area of light in the entire wavelength band. That is, the spectral area of light in the saturation enhancement band (455 nm or more) may be 65% or more of the spectral area of light in the wavelength band of 400 nm to 500 nm.

Furthermore, the spectral area of light in the desaturation band among light emitted from the light emitting package may be less than 20% of the spectral area of light in the entire wavelength band. That is, the spectral area of light in the saturation enhancement band (455 nm or more) may be 80% or more of the spectral area of light in the wavelength band of 400 nm to 500 nm.

In accordance with a further embodiment of the present invention, a backlight unit including a support substrate having a circuit formed thereon, a plurality of light emitting devices, and a molding portion. The plurality of light emitting devices may be mounted on the support substrate to be electrically connected to the support substrate. The molding portion may cover the light emitting devices and may be formed of a light transmissive material. Each of the plurality of light emitting devices may include a first light emitting device including: a light generation layer emitting light in a blue wavelength band; and an electrode electrically connected to the light generation layer. The first light emitting device may include a first light emitting surface emitting the light, a second light emitting surface, and a third light emitting surface, through which the light is emitted. The light generation layer may include a first semiconductor layer, a second semiconductor layer, and an active layer formed between the first semiconductor layer and the second semiconductor layer. The electrode may include a first electrode electrically connected to the first semiconductor layer and a second electrode electrically connected to the second semiconductor layer. The second light emitting surface may be a plane facing the support substrate, the first light emitting surface may be a plane opposite to the second light emitting surface, and the third light emitting surface may be a side surface connecting the first light emitting surface to the second light emitting surface. The quantity of light in a desaturation band among light emitted through the molding portion may be lower than the quantity of light in other wavelength bands. That is, the quantity of light in a saturation enhancement band may be higher than the quantity of light in other wavelength bands.

The desaturation band may be in the range of 400 nm to less than 455 nm.

The saturation enhancement band may be in the wavelength band of 455 nm or more.

Light emitted from the first light emitting device may have a peak wavelength of 450 nm to 460 nm.

The active layer may be formed of a nitride-based material containing indium.

The active layer may have an indium content of 14% or more.

The active layer may be composed of InₓGa₍₁₋ₓ₎N, where x is greater than or equal to 0.14.

The backlight unit may further include a filter blocking or absorbing light in the desaturation band. The filter may cover the first light emitting surface of the first light emitting device.

The filter may be formed of an insulating material. The insulating material for the filter may include at least one selected from among SiO₂, TiO₂, Nb₂O₅, MgO₂, Al₂O₃, ZrN, ZrO₂, and AlN.

The filter may be a distributed Bragg reflector.

The filter may include a transparent resin and a light absorptive material dispersed in the transparent resin.

The light absorptive material may include at least one selected from among Ca, C, SiO₂, and TiO₂.

According to one embodiment, the first electrode and the second electrode of the first light emitting device may be disposed between the light generation layer and the support substrate.

The filter may include a first filter covering the first light emitting surface and a second filter covering at least part of the second light emitting surface on which the electrode is not formed.

According to another embodiment, at least one of the first electrode and the second electrode of the first light emitting device may be formed on one surface of the light generation layer. The one surface of the light generation layer may be a plane facing the first light emitting surface.

The filter may cover a portion of the first light emitting surface on which the electrode is not formed.

The filter may cover at least part of the third light emitting surface of the first light emitting device

The molding portion may further include a wavelength conversion material.

The wavelength conversion material may include a material emitting green light excited by light emitted from the first light emitting device and a material emitting red excited by light emitted from the first light emitting device.

The light emitting device may further include a second light emitting device and a third light emitting device. The second light emitting device may emit light in a green wavelength band and the third light emitting device may emit light in a red wavelength band.

The support substrate may include a circuit portion formed with a control circuit and having a structure elongated in one direction, and a plurality of mounting sections. The plurality of mounting sections may receive the plurality of light emitting devices mounted thereon and may be formed with wires electrically connecting the control circuit of the circuit portion to the plurality of light emitting devices.

Each of the mounting sections may have one end connected to a long side surface of the circuit portion and extending from the long side surface of the circuit portion. In addition, the mounting sections may be spaced apart from each other.

A corner at which side surfaces of the plurality of mounting sections meet the side surface of the circuit portion may be a curved surface.

The backlight unit may further include a reflective sheet formed on an upper surface of the support substrate and having a plurality of holes exposing the upper surface of the support substrate. The light emitting devices may be mounted in the holes of the reflective sheet, respectively.

The backlight unit may further include a plurality of reflective pillars disposed between the plurality of light emitting devices. The reflective sheet may further include a plurality of holes receiving lower ends of the plurality of reflective pillars, respectively.

The backlight unit may further include a reflective sidewall surrounding a side surface of each of the plurality of light emitting devices. The side surface of each of the light emitting devices may be spaced apart from the reflective sidewall. In addition, the molding portion may fill an inner space between the reflective sidewalls, in which the light emitting device is disposed.

It is to be understood that both the foregoing general description and the following detailed description are exemplary and explanatory and are intended to provide further explanation of the disclosure as claimed.

### [Advantageous Effects]

A light emitting device, a light emitting package, and a backlight unit including the same according to embodiments of the present invention may block or reduce emission of light in a wavelength band reducing saturation of light, and may increase the ratio of light in a wavelength band that enhances the saturation of light. Therefore, the light emitting device, the light emitting package, and the backlight unit including the same according to the embodiments of the present invention can improve saturation of light emitted therefrom.

### [Description of Drawings]

The accompanying drawings, which are included to provide a further understanding of the disclosure and are incorporated in and constitute a part of this specification, illustrate exemplary embodiments of the disclosure, and together with the description serve to explain the inventive concepts.
FIG. 1 is a sectional view of a light emitting device according to a first embodiment of the present invention.
FIG. 2 is a sectional view of a light emitting package according to a first embodiment of the present invention.
FIG. 3 is a view comparing a light spectrum of the light emitting package according to the first embodiment of the present invention with the spectrum of comparative white light.
FIG. 4 is an exemplary view of a light emitting package according to a second embodiment of the present invention.
FIG. 5 is an exemplary view of a light emitting package according to a third embodiment of the present invention.
FIG. 6 is an exemplary view of a light emitting package according to a fourth embodiment of the present invention.
FIG. 7 is a view of one example of a light spectrum of the light emitting package according to the fourth embodiment of the present invention.
FIG. 8 is an exemplary view of a light emitting package according to a fifth embodiment of the present invention.
FIG. 9 is a view of one example of a light spectrum of the light emitting package according to the fifth embodiment of the present invention.
FIG. 10 is an exemplary view of a light emitting package according to a sixth embodiment of the present invention.
FIG. 11 is an exemplary view of a light emitting package according to a seventh embodiment of the present invention.
FIG. 12 is an exemplary view of a light emitting package according to an eighth embodiment of the present invention.
FIG. 13 is a view of light spectra of the light emitting packages according to the sixth to eighth embodiments of the present invention.
FIG. 14 is an exemplary view of a light emitting package according to a ninth embodiment of the present invention.
FIG. 15 is an exemplary view of a light emitting package according to a tenth embodiment of the present invention.
FIG. 16 is a view comparing a light spectrum of the light emitting package according to the tenth embodiment of the present invention with the spectrum of comparative white light.
FIG. 17 is an exemplary view of a light emitting package according to an eleventh embodiment of the present invention.
FIG. 18 is an exemplary view of a light emitting package according to a twelfth embodiment of the present invention.
FIG. 19 is an exemplary view of a light emitting package according to a thirteenth embodiment of the present invention.
FIG. 20 is an exemplary view of a light emitting package according to a fourteenth embodiment of the present invention.
FIG. 21 is an exemplary view of a light emitting package according to a fifteenth embodiment of the present invention.
FIG. 22 is an exemplary view of a light emitting package according to a sixteenth embodiment of the present invention.
FIG. 23 is an exemplary view of a mother substrate for a backlight unit.
FIG. 24 is an exemplary view illustrating a plurality of circuit boards separated from the mother substrate according to the embodiment.
FIG. 25 is an exemplary view of a backlight unit according to a first embodiment of the present invention.
FIG. 26 is a view of another example of a connecting portion of the circuit board.
FIG. 27 is a view of a further embodiment of the connecting portion of the circuit board.
FIG. 28 is a perspective view of a backlight unit according to a second embodiment of the present invention.
FIG. 29 is a cross-sectional view (A1-A2) of the backlight unit according to the second embodiment of the present invention.
FIG. 30 is a plan view of a backlight unit according to a third embodiment of the present invention.
FIG. 31 is a cross-sectional view (B1-B2) of the backlight unit according to the third embodiment of the present invention.
FIG. 32 is a plan view of a backlight unit according to a fourth embodiment of the present invention.
FIG. 33 is a cross-sectional view (C1-C2) of the backlight unit according to the fourth embodiment of the present invention.

### [Mode for Invention]

Hereinafter, embodiments of the present invention will be described with reference to the accompanying drawings. It should be understood that the embodiments are provided for complete disclosure and thorough understanding of the present invention by those skilled in the art. Therefore, the present invention is not limited to the following embodiments and may be embodied in different ways. In addition, the drawings may be exaggerated in width, length, and thickness of components for descriptive convenience and clarity only. Like components will be denoted by like reference numerals throughout the specification.

Hereinafter, a light emitting device, a light emitting package, a backlight unit including the same, a display apparatus including the same, and a lighting apparatus including the same according to the present invention will be described in detail.

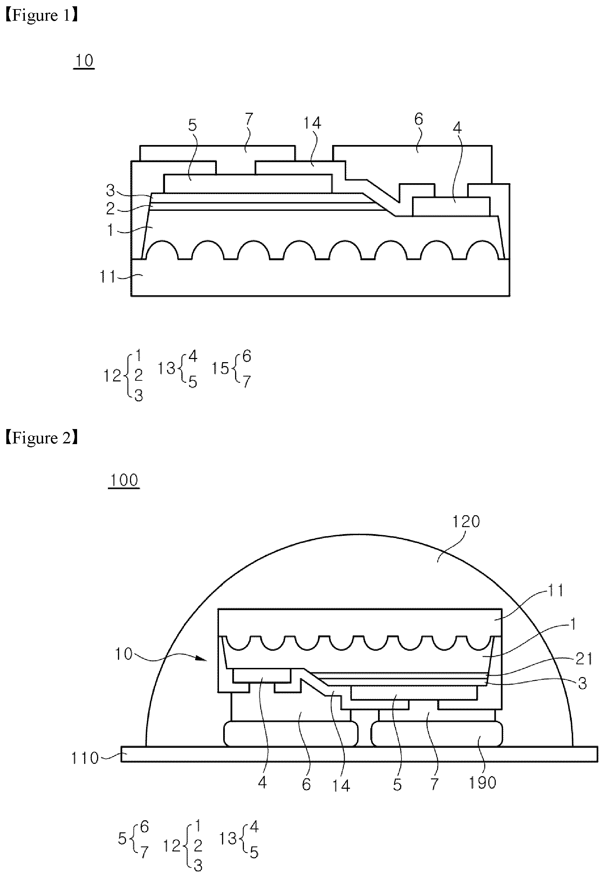

FIG. 1 to FIG. 3 are views of a light emitting device according to a first embodiment of the present invention.

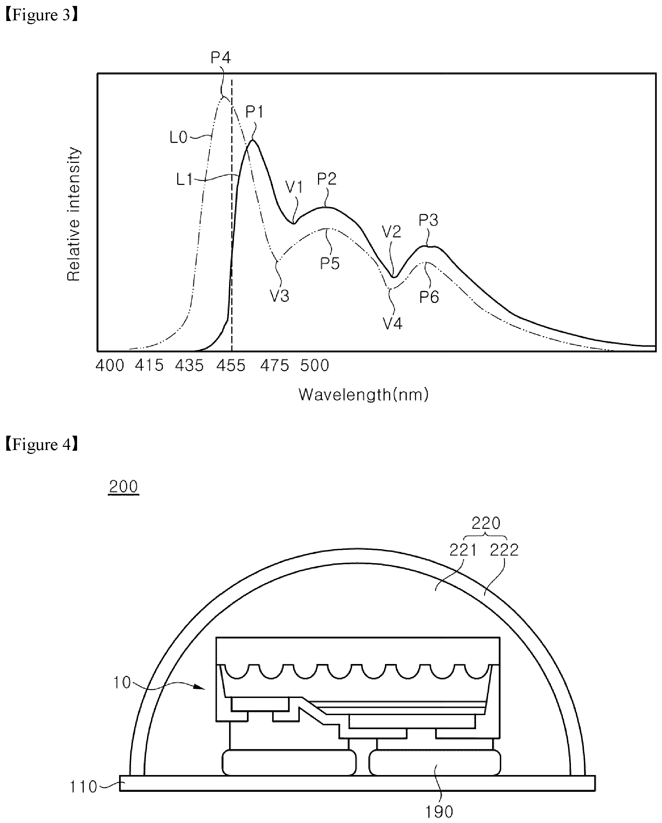

FIG. 1 is a sectional view of a light emitting device according to a first embodiment of the present invention. FIG. 2 is a sectional view of a light emitting package according to a first embodiment of the present invention. FIG. 3 is a view comparing a light spectrum of the light emitting package according to the first embodiment of the present invention with the spectrum of comparative white light.

Referring to FIG. 1, the light emitting device 10 according to the first embodiment may include a growth substrate 11, a light generation layer 12, an electrode 13, an insulating layer 14, and an electrode pad 15.

The growth substrate 11 may be selected from any substrates capable of growing the light generation layer 12 thereon. For example, the growth substrate 11 may be formed of a material, such as sapphire, silicon, silicon carbide, gallium nitride, aluminum nitride, or the like. Although the light emitting device 10 includes the growth substrate 11 in this embodiment, the growth substrate 11 may be removed after formation of the light generation layer 12.

The light generation layer 12 may be formed on the growth substrate 11.

The light generation layer 12 may include a first semiconductor layer 1, a second semiconductor layer 3, and an active layer 2 formed between the first semiconductor layer 1 and the second semiconductor layer 3.

All of the first semiconductor layer 1, the second semiconductor layer 3 and the active layer 2 may be formed of a nitride-based material. For example, the first semiconductor layer 1 may be a semiconductor layer in which a nitride-based material is doped with an n-type impurity. The second semiconductor layer 3 may be a semiconductor layer in which a nitride-based material is doped with a p-type impurity. For example, the n-type impurity may include Si, Ge, Se, Te, O, C, Sn, and the like. In addition, the p-type impurity may include Mg, Zn, Ca, Sr, Ba, and the like.

Although the first semiconductor layer 1 includes an n-type impurity and the second semiconductor layer 3 includes a p-type impurity in this embodiment, the first semiconductor layer 1 may include a p-type impurity and the second semiconductor layer 3 may include an n-type impurity.

In the active layer 2, electrons (or holes) injected through the first semiconductor layer 1 and holes (or electrons) injected through the second semiconductor layer 3 meet each other to emit light due to an energy band gap according to the forming material. The active layer 2 may include a single quantum well structure or a multi-quantum well structure.

For the light generation layer 12 to generate blue light, the active layer 2 may be formed of a nitride-based material.

According to this embodiment, the active layer 2 may be formed of nitride-based material containing indium (In). For example, the active layer 2 may be composed of InₓGa₍₁₋ₓ₎N (x being greater than or equal to 0). In addition, x may be greater than or equal to 0.14. That is, the nitride-based material for the active layer 2 may have an indium content of 14% or more.

When the active layer 2 is formed of a nitride-based material having an indium content of 14% or more, the blue light may have a peak wavelength of 450 nm or more.

When the active layer 2 is formed of a nitride-based material having an indium content of less than 14%, the blue light may have a peak wavelength of less than 450 nm.

Thus, in the light emitting device 10 according to this embodiment, the active layer 2 may be formed of a nitride-based material containing 14% or more of indium to generate blue light having a peak wavelength of 450 nm or more, thereby achieving reduction in quantity of light in the wavelength band of 415 nm to less than 455 nm.

The active layer 2 and the conductive semiconductor layer may be partially removed to form a mesa structure in which the first semiconductor layer 1 is partially exposed.

Irregularities may be formed on a lower surface of the light generation layer 12 or an upper surface of the growth substrate 11. The irregularities may be formed by at least one of wet etching, dry etching, and electrochemical etching. For example, the irregularities may be formed by various methods, such as PEC etching or an etching method using an etching solution containing KOH and NaOH. By formation of the irregularities, surface roughness of the lower surface of the light generation layer 12 or the upper surface of the growth substrate 11 increases, thereby improving light extraction efficiency of the light emitting device 10.

Although the light emitting device 10 according to this embodiment has the irregularities on the lower surface of the light generation layer 12 and the upper surface of the growth substrate 11, the irregularities may be omitted.

The first electrode 4 and the second electrode 5 may be formed on the light generation layer 12.

The first electrode 4 may be formed on the first semiconductor layer 1 exposed by the mesa structure. The first electrode 4 may be electrically connected to the first semiconductor layer 1. In addition, the second electrode 5 may be formed on the second semiconductor layer 3. The second electrode 5 may be electrically connected to the second semiconductor layer 3.

The first electrode 4 and the second electrode 5 may be formed of a conductive material. The first electrode 4 and the second electrode 5 may be formed of a conductive metal. For example, the first electrode 4 and the second electrode 5 may be formed of various metals, such as Al, Ti, Cr, Ni, Au, Ag, Ti, Sn, Ni, Cr, W, Cu, and alloys thereof. In addition, the first electrode 4 and the second electrode 5 may be composed of a single layer or multiple layers.

The first electrode 4 and the second electrode 5 may be spaced apart from each other to be insulated from each other.

Referring to FIG. 1, the first electrode 4 directly adjoins the first semiconductor layer 1 to be electrically connected thereto and the second electrode 5 directly adjoins the second semiconductor layer 3 to be electrically connected thereto. However, it should be understood that the structure of the light emitting device 10 according to this embodiment is not limited thereto. For example, at least one conductive layer formed of a conductive material may be formed between the first semiconductor layer 1 and the first electrode 4 and between the second semiconductor layer 3 and the second electrode 5. The first semiconductor layer 1 may be electrically connected to the first electrode 4 through the conductive layer and the second semiconductor layer 3 may be electrically connected to the second electrode 5 therethrough.

The insulating layer 14 may be formed to partially cover a side surface of the light generation layer 12, an upper surface of the light generation layer 12, a side surface of the electrode 13, and an upper surface of the electrode 13. Accordingly, the first electrode 4 may be insulated from the second electrode 5 by the insulating layer 14. In addition, since the insulating layer 14 covers the side surface of the light generation layer 12, the insulating layer 14 serves to protect the light generation layer 12.

The insulating layer 14 may be formed of an insulating material. For example, the insulating layer 14 may composed of at least one layer formed of SiO₂, SiNx, MgF₂, or the like. In addition, the insulating layer 14 may include a distributed Bragg reflector in which insulating materials having different indexes of refraction are alternately stacked.

The insulating layer 14 may include a plurality of openings. The openings of the insulating layer 14 may be formed on the first electrode 4 to expose the first electrode 4. In addition, the openings of the insulating layer 14 may be formed on the second electrode 5 to expose the second electrode 5.

A first electrode pad 6 and a second electrode pad 7 may be formed to be spaced apart from each other on the insulating layer 14. The first electrode pad 6 and the second electrode pad 7 serve to electrically connect the light emitting device 10 to an external component.

The first electrode pad 6 may be formed on the first electrode 4 to be electrically connected to the first electrode 4 through the openings of the insulating layer 14. In addition, the first electrode pad 6 may cover not only the first electrode 4 but also some portions of upper surfaces of the first semiconductor layer 1 and the second semiconductor layer 3. Here, the first electrode pad 6 may be insulated from the second semiconductor layer 3 by the insulating layer 14 formed between the first electrode pad 6 and the light generation layer 12.

In addition, the second electrode pad 7 may be formed on the second electrode 5 to be electrically connected to the second electrode 5 through the openings of the insulating layer 14. In addition, the second electrode pad 7 may cover not only an upper surface of the second electrode 5 but also some portions of the upper surfaces of the first semiconductor layer 1 and the second semiconductor layer 3. Here, the second electrode pad 7 may be insulated from the first semiconductor layer 1 by the insulating layer 14 formed between the second electrode pad 7 and the light generation layer 12.

The first electrode pad 6 and the second electrode pad 7 may be formed of any kind of conductive material that can be electrically connected to the first electrode 4 and the second electrode 5. For example, the first electrode pad 6 and the second electrode pad 7 may be formed of a metal, such as Cu, Pt, Au, Ti, Ni, Al, and Ag.

Referring to FIG. 1, the first electrode pad 6 directly adjoins the first electrode 4 and the second electrode pad 7 directly adjoins the second electrode 5. However, it should be understood that the structure of the light emitting device 10 according to this embodiment is not limited thereto. For example, at least one conductive layer formed of a conductive material may be disposed between the first electrode pad 6 and the first electrode 4 and between the second electrode pad 7 and the second electrode 5. Here, the first electrode pad 6 may be electrically connected to the first electrode 4 through the conductive layer and the second electrode pad 7 may be electrically connected to the second electrode 5 therethrough.

The light emitting device 10 according to this embodiment has a structure in which the electrode 13 and the electrode pad 15 are placed in the same direction. Accordingly, the light emitting device 10 according to this embodiment may be coupled to a support substrate 110 through flip-chip bonding, as shown in FIG. 2.

Referring to FIG. 2, a light emitting package 100 according to a first embodiment may include a light emitting device 10, a support substrate 110, and a molding portion 120.

The support substrate 110 may be a substrate formed with wires. The support substrate 110 may be formed of a wire electrically connected to the light emitting device 10 and may be formed of any material capable of supporting the light emitting device 10. For example, the support substrate 110 may be a printed circuit board.

In addition, the wire of the support substrate 110 serves to electrically connect the light emitting device 10 to an external component. Voltage and current may be applied from the external component to the light emitting device 10 through the wire of the support substrate 110. The light emitting device 10 may emit light by voltage and current applied through the wire of the support substrate 110.

The light emitting device 10 may be disposed on the support substrate 110. In this embodiment, the light emitting device 10 is the light emitting device 10 shown in FIG. 1.

The light emitting device 10 according to this embodiment may include a first light emitting surface, a second light emitting surface, and a third light emitting surface, through which the light is emitted. The first light emitting surface corresponds to an upper surface of the light emitting device 10, the second light emitting surface corresponds to a lower surface of the light emitting device 10, and the third light emitting surface corresponds to a side surface of the light emitting device 10.

That is, referring to FIG. 2, the first light emitting surface may constitute an upper surface of the growth substrate 11. The second light emitting surface may constitute one surface of the light generation layer 12 formed with the electrode 13, or the insulating layer 3 formed under the light generation layer. In addition, the third light emitting surface may constitute a side surface of the growth substrate 11 and a side surface of the light generation layer 12. Here, when the growth substrate 11 is omitted from the light emitting device 10, the first light emitting surface may constitute the other surface opposite to one surface of the light generation layer 12 formed with the electrode 13, and the third light emitting surface may constitute the side surface of the light generation layer 12.

In FIG. 2, the first light emitting surface constitutes the upper surface of the light emitting device 10 and the second light emitting surface constitutes the lower surface of the light emitting device 10. However, when the light emitting device 10 is disposed on the support substrate 10 in an opposite arrangement to the arrangement shown in FIG. 2, the first light emitting surface may constitute one surface of the light generation layer on which the electrode is formed or the insulating layer on one surface of the light generation layer. In addition, the second light emitting surface may constitute one surface of the growth substrate or the other surface of the light generation layer when the growth substrate is omitted. Here, the one surface of the growth substrate and the other surface of the light generation layer are directed in an opposite direction to one surface of the light generation layer.

A bonding layer 190 may be further formed between the light emitting device 10 and the support substrate 110. The adhesive layer 190 may be formed of a conductive material having bonding strength. For example, the adhesive layer 190 may be formed of solders.

The bonding layer 190 may be formed between the first electrode pad 6 of the light emitting device 10 and the support substrate 110 and between the second electrode pad 7 of the light emitting device 10 and the support substrate 110. The bonding layer 190 may electrically connect wires of the light emitting device 10 and the support substrate 110 to each other while securing the light emitting device 10 to the support substrate 110.

The molding portion 120 may cover the light emitting device 10. The molding portion 120 may be formed of a light transmissive material. For example, the molding portion 120 may be formed of at least one selected from among a transparent resin, glass and ceramics. Here, the transparent resin may be an epoxy resin, a silicone resin, or the like.

In addition, the molding portion 120 may include a wavelength conversion material. The wavelength conversion material may be dispersed in the molding portion 120. Hereinafter, phosphors will be illustrated as the wavelength conversion material by way of example. However, it should be understood that the kind of wavelength conversion material is not limited to the phosphors. The wavelength conversion material may be selected from any materials, such as phosphors, quantum dots, and the like, which can convert the wavelength of light emitted from the light emitting device 10. For example, the wavelength conversion material may include a material emitting green light, a material emitting red light, and a material emitting yellow light.

In this embodiment, the wavelength conversion material may include a red phosphor and a green phosphor. Alternatively, the wavelength conversion material may include a red phosphor, a green phosphor and a yellow phosphor.

Referring to FIG. 2, the molding portion 120 may have a dome structure composed of a curved surface. However, it should be understood that the structure of the molding portion 120 is not limited thereto. The molding portion 120 may have a structure in which at least one of an upper surface and a side surface is a flat surface rather than a curved surface. Alternatively, the molding portion 120 may be disposed on the light emitting device 10 and formed as a plate or sheet spaced apart from the light emitting device 10.

Some fraction of light emitted from the light emitting device 10 may be converted a wavelength by each of the phosphors while passing through the molding portion 120. Accordingly, the light emitting package 100 may emit white light in which blue light, red light, and green light are mixed, or white light in which blue light, red light, green light, and yellow light are mixed.

Light emitted from the light emitting package 100 may have spectrum characteristics, as shown in FIG. 3.

FIG. 3 shows spectra of white light L1 (hereinafter, white light according to this embodiment) emitted from the light emitting package 100 according to this embodiment and white light L0 (hereinafter, comparative white light) emitted from another light emitting package.

The comparative white light L0 is white light emitted from a light emitting package having a light emitting device that includes an active layer 2 comprising a nitride-based material containing less than 14% of indium.

The light emitting package emitting the comparative white light L0 has the same structure as the light emitting package 100 according to this embodiment shown in the FIG. 2 excluding the components of the active layer 2 of the light emitting device.

Referring to FIG. 3, the comparative white light L0 and the white light L1 according to this embodiment may include a peak wavelength in a blue wavelength band, a peak wavelength in a green wavelength band, and a peak wavelength in a red wavelength band.

The spectrum of the white light L1 according to this embodiment may have a first peak wavelength P1, a second peak wavelength P2, and a third peak wavelength P3. The first peak wavelength P1, which is a peak wavelength in the blue wavelength band, may be located between 450 nm and 500 nm. Specifically, the first peak wavelength P1 may be located between 450 nm and 470 nm, more specifically between 455 nm and 465 nm. In addition, the second peak wavelength P2, which is a peak wavelength in the green wavelength band, may be located between 500 nm and 580 nm. Specifically, the second peak wavelength P2 may be located between 530 nm and 550 nm. In addition, the third peak wavelength P3, which is a peak wavelength in the red wavelength band, may be located between 600 nm and 680 nm.

The spectrum of the comparative white light L0 may have a fourth peak wavelength P4, a fifth peak wavelength P5, and a sixth peak wavelength P6. The fourth peak wavelength P4, which is a peak wavelength in the blue wavelength band, may be located between 440 nm and 450 nm. In addition, the fifth peak wavelength P5, which is a peak wavelength in the green wavelength band, may be located between 500 nm and 580 nm. In addition, the sixth peak wavelength P6, which is a peak wavelength in the red wavelength band, may be located between 600 nm and 680 nm.

In general, blue light is in the wavelength band of 400 nm to 500 nm. Here, the lower the wavelength band of light, the closer the light is to the UV wavelength band. Accordingly, as the fraction of light close to the UV wavelength band increases, the saturation of blue light can decrease.

Referring to FIG. 3, it can be seen that the comparative white light L0 has a higher ratio of blue light in the wavelength band of 400 nm to less than 455 nm, which corresponds to a desaturation band, than in other wavelength bands. In particular, it can be seen that the comparative white light L0 has a higher ratio of blue light in the wavelength band of 415 nm to less than 455 nm.

In addition, referring to FIG. 3, comparing the first peak wavelength P1 of the white light L1 according to this embodiment with the fourth peak wavelength P4 of the comparative white light L0, it can be seen that the first peak wavelength P1 is a longer wavelength than the fourth peak wavelength P4. That is, according to this embodiment, as the active layer 2 is formed of a nitride-based material containing 14% or more of indium, it is possible to shift the peak wavelength in the blue wavelength band in a longer wavelength direction.

Thus, according to this embodiment, the spectrum of the white light L1 in the wavelength band of 415 nm to less than 455 nm, that is, in the desaturation band, may have a smaller area than the spectrum of the comparative white light L0. That is, the spectral area of light in the wavelength band of 455 nm or more, that is, in the saturation enhancement band, may increase, as compared to the entire spectral area.

Further, referring to FIG. 3, it can be seen that the white light according to this embodiment has a lower ratio of blue light in the desaturation band than in other wavelength bands. That is, it can be seen that, in the blue wavelength band of 400 nm to 500 nm, the spectral area of light in the wavelength band of 400 nm to less than 455 nm, that is, in the desaturation band, is smaller than the spectral area of light in the wavelength band of 455 nm to 500 nm. In other words, the light emitting package according to this embodiment may have a greater quantity of light in the wavelength band of 455 nm to 500 nm, that is, in the saturation enhancement band, than the quantity of light in the desaturation band.

The light emitting device in the light emitting package according to this embodiment emits blue light. Thus, the light emitting device according to this embodiment may emit a greater quantity of light in the saturation enhancement band than the quantity of light in the desaturation band.

In the spectrum of the white light L1 according to this embodiment, a ratio of spectral area B in the saturation enhancement band to the entire spectral area A may satisfy a relation: 0.5 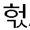 /A<1, specifically 0.65 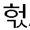 /A<1, more specifically 0.8 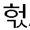 /A<1. That is, in the blue wavelength band of the white light L1 according to this embodiment, the spectral area of light in the saturation enhancement band may be 50% or more of the spectral area (entire spectral area) in the entire wavelength band. Further, the spectral area of light in the saturation enhancement band may be 65% or more, more specifically 80% or more, of the entire spectral area in the entire wavelength band.

On the contrary, in the white light L1 according to this embodiment, the ratio of spectral area B in the desaturation band to the entire spectral area A in the entire wavelength band may be less than 50%. Specifically, in the white light L1 according to this embodiment, the spectral area in the desaturation band may be less than 35%, more specifically less than 20%, of the entire spectral area A in the entire wavelength band.

As such, the light emitting device 10 (see FIG. 1) and the light emitting package 100 (see FIG. 2) according to this embodiment can increase the ratio of blue light in the saturation enhancement band while decreasing the ratio of blue light in the desaturation band. That is, the light emitting device 10 (see FIG. 1) and the light emitting package 100 (see FIG. 2) according to this embodiment may increase the quantity of light (or spectral area) in the saturation enhancement band through decrease in quantity of light in the desaturation band by adjusting the content of indium in the active layer 2.

If the peak wavelength in the blue wavelength band is too far from the peak wavelength in the green wavelength band, the peak wavelength in the blue wavelength band may be placed in a short wavelength region within the blue wavelength band. In this case, the area of the desaturation band increases, indicating that the ratio of blue light causing reduction in saturation of the white light emitted from the light emitting package increases and the ratio of blue light causing increase in saturation of the white light decreases. Accordingly, the light emitting package may emit blue light with low saturation.

Further, if the peak wavelength in the blue wavelength band is too close to the peak wavelength in the green wavelength band, the peak wavelength in the blue wavelength band becomes close to the green wavelength band. In this case, the total area of the blue wavelength band is excessively reduced and provides an unsuitable ratio between blue light, green light, and red light, thereby making it difficult to implement white light of a desired color.

In order to solve the above problem, the white light L1 according to this embodiment may have a difference of 50 nm to 100 nm between the first peak wavelength P1 and the second peak wavelength P2. Specifically, the white light L1 may have a difference of 60 nm to 100 nm, more specifically 70 nm to 90 nm, between the first peak wavelength P1 and the second peak wavelength P2.

As such, the light emitting package 100 (see FIG. 2) according to this embodiment may increase the quantity of light in the saturation enhancement band while decreasing the quantity of light in the desaturation band, thereby implementing the white light L1 having similar saturation to or the same saturation as white light in the related art.

Further, according to the embodiment of the present invention, the first peak wavelength P1 may have a full width at half maximum (FWHM) of 20 nm or less. More specifically, the first peak wavelength P1 may have a full width at half maximum of 10 nm to 20 nm.

If the full width at half maximum of the first peak wavelength P1 is greater than 20 nm, the spectrum is broadly distributed in the blue wavelength band, thereby increasing the area of light in the desaturation band. That is, if the full width at half maximum of the first peak wavelength P1 is greater than 20 nm, the quantity and ratio of blue light in a wavelength band causing deterioration in saturation can increase in the wavelength band of 400 nm to 500 nm. Further, if the full width at half maximum of the first peak wavelength P1 is greater than 20 nm, the spectrum is broadly distributed in the blue wavelength band, thereby causing reduction in saturation of blue light.

In addition, if the full width at half maximum of the first peak wavelength P1 is too small, the spectral area in the blue wavelength band can be reduced and the entire spectral area of white light can be reduced. Accordingly, if the full width at half maximum of the first peak wavelength P1 is too small, the quantity of light emitted from the light emitting device decreases, thereby causing color unbalance of white light. Furthermore, the quantity of light emitted from the light emitting package can be reduced through reduction in the entire spectral area of white light.

Further, the spectrum of the white light L1 according to this embodiment may have a first valley wavelength V1 having minimum intensity between the first peak wavelength P1 and the second peak wavelength P2 and a second valley wavelength V2 having minimum intensity between the second peak wavelength P2 and the third peak wavelength P3.

In addition, the spectrum of the comparative white light L0 may have a third valley wavelength V3 having minimum intensity between the fourth peak wavelength P4 and the fifth peak wavelength P5 and a fourth valley wavelength V4 having minimum intensity between the fifth peak wavelength P5 and the sixth peak wavelength P6.

Referring to FIG. 3, the first valley wavelength V1 of the white light L1 according to this embodiment is higher than the third valley wavelength V3 of the comparative white light L0. That is, in the white light L1 according to this embodiment, the area of the desaturation band is reduced and the area of other bands excluding the desaturation band is increased in the blue wavelength band, as compared to the comparative white light L0. Accordingly, the entire area of the blue wavelength band of the white light L1 according to this embodiment may remain similar to that of the comparative white light L0 without significant decrease in the entire area of the blue wavelength band. Thus, the light emitting device 10 (see FIG. 1) and the light emitting package 100 (see FIG. 2) according to this embodiment may maintain the quantity of blue light.

In addition, comparing the white light L1 according to this embodiment with the comparative white light L0, the second peak wavelength P2 is greater than the fifth peak wavelength P5, the third peak wavelength P3 is greater than the sixth peak wavelength P6, and the second valley wavelength V2 is greater than the fourth valley wavelength V4. Accordingly, although the white light L1 according to this embodiment has a smaller area of the desaturation band than the comparative white light L0, the white light L1 according to this embodiment has a larger area in other bands than the comparative white light L0. As a result, the light emitting package 100 (see FIG. 2) according to this embodiment may maintain the quantity of the white light L1.

As such, the light emitting device 10 (see FIG. 1) and the light emitting package 100 (see FIG. 2) according to this embodiment may prevent color unbalance and reduction in quantity of light by increasing the quantity of light in the saturation enhancement band while decreasing the quantity of light in the desaturation band. In addition, it is possible to implement a display with improved properties through increase in ratio of light in the saturation enhancement band in the wavelength band of 400 nm to 500 nm.

That is, the spectral area of light in the saturation enhancement band (455 nm or more) emitted from the light emitting package may be 50% or more of the spectral area of light in the wavelength band of 400 nm to 500 nm.

The spectral area of light in the saturation enhancement band (455 nm or more) may be 65% or more of the spectral area of light in the wavelength band of 400 nm to 500 nm.

The spectral area of light in the saturation enhancement band (455 nm or more) may be 80% or more of the spectral area of light in the wavelength band of 400 nm to 500 nm.

FIG. 4 is an exemplary view of a light emitting package according to a second embodiment of the present invention.

The light emitting package 200 according to the second embodiment may include a light emitting device 10, a support substrate 110, and a molding portion 220.

The light emitting device 10 and the support substrate 110 according to this embodiment are the same as the light emitting device 10 and the support substrate 110 of the light emitting package 100 according to the first embodiment shown in FIG. 2. Accordingly, for detailed description of the light emitting device 10 according to this embodiment and the support substrate 110, refer to description of FIG. 2.

According to this embodiment, the molding portion 220 may include a first molding portion 221 and a second molding portion 222. The first molding portion 221 may be formed on the support substrate 110 to cover the light emitting device 10. In addition, the second molding portion 222 may be formed on the first molding portion 221 to cover the first molding portion 221.

The first molding portion 221 and the second molding portion 222 may be formed of a light transmissive material. For example, the first molding portion 221 and the second molding portion 222 may be formed of at least one selected from among a transparent resin, glass, and ceramics. In addition, the transparent resin may be an epoxy resin, a silicone resin, or the like.

In addition, at least one of the first molding portion 221 and the second molding portion 222 may include a wavelength conversion material. For example, the first molding portion 221 may include a red phosphor and a green phosphor, and the second molding portion 222 may not include the wavelength conversion material, or vice versa. Alternatively, the first molding portion 221 may include a red phosphor and the second molding portion 222 may include a green phosphor, or vice versa. Alternatively, the first molding portion 221 may include a red phosphor, a green phosphor, and a yellow phosphor, and the second molding portion 222 may not include the wavelength conversion material, or vice versa. Alternatively, the first molding portion 221 may include at least one selected from among a red phosphor, a green phosphor, and a yellow phosphor, and the second molding portion 222 may include a phosphor not included in the first molding portion 221. Alternatively, the first molding portion 221 and the second molding portion 222 may include the same at least one phosphor.

In addition, the second molding portion 222 may allow light to be emitted in a widely dispersed shape from the light emitting package 200 or to be emitted therefrom to be concentrated on a certain region. That is, the second molding portion 222 may be an optical lens that controls the beam angle of light emitted from the light emitting package 200.

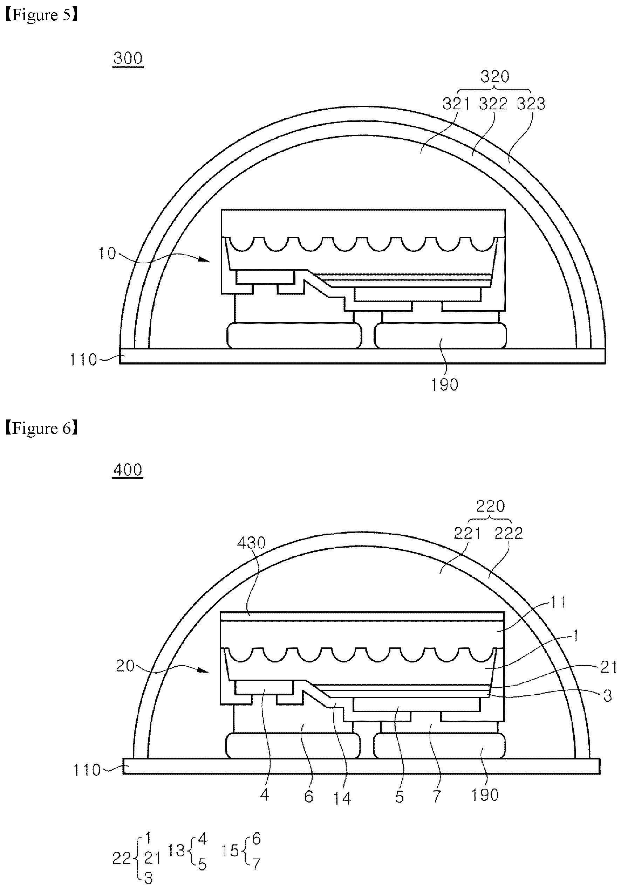

FIG. 5 is an exemplary view of a light emitting package according to a third embodiment of the present invention.

The light emitting package 300 according to the third embodiment may include a light emitting device 10, a support substrate 110, and a molding portion 320.

The light emitting device 10 and the support substrate 110 according to this embodiment are the same as the light emitting device 10 and the support substrate 110 of the light emitting package 100 according to the first embodiment shown in FIG. 2. Accordingly, for detailed description of the light emitting device 10 according to this embodiment and the support substrate 110, refer to description of FIG. 2.

According to this embodiment, the molding portion 320 may include a first molding portion 321, a second molding portion 322, and a third molding portion 323. The first molding portion 321 may be formed on the support substrate 110 to cover the light emitting device 10. The second molding portion 322 may be formed on the first molding portion 321 to cover the first molding portion 321. In addition, the third molding portion 323 may be formed on the second molding portion 322 to cover the second molding portion 322.

The first to third molding portions 321, 322, 323 may be formed of a light transmissive material. For example, the first to third molding portions 321, 322, 323 may be formed of at least one selected from among a transparent resin, glass, and ceramics. In addition, the transparent resin may be an epoxy resin, a silicone resin, or the like.

In addition, at least one of the first molding portion 321 and the second molding portion 322 may include a wavelength conversion material. The wavelength conversion material may include a green phosphor and a red phosphor. Alternatively, the wavelength conversion material may include a green phosphor, a red phosphor, and a yellow phosphor.

For example, the first to third molding portions 321, 322, 323 may include different phosphors. Alternatively, one of the first to third molding portions 321, 322, 323 may include all types of phosphors. Alternatively, two of the first to third molding portions 321, 322, 323 may include different types of phosphors or may include at least one type of phosphor. As such, various types of wavelength conversion materials may be present in the first to third molding portions 321, 322, 323 in various ways.

In addition, the third molding portion 323 may allow light to be emitted in a widely dispersed shape from the light emitting package 300 or to be emitted therefrom to be concentrated on a certain region. That is, the third molding portion 323 may be an optical lens that controls the beam angle of light emitted from the light emitting package 300.

Although the molding portion 220 of the light emitting package 200 according to the second embodiment shown in FIG. 4 and the molding portion 320 of the light emitting package 300 according to the third embodiment shown in FIG. 5 have the dome structure, it should be understood that the structure of the molding portion may be modified in various ways.

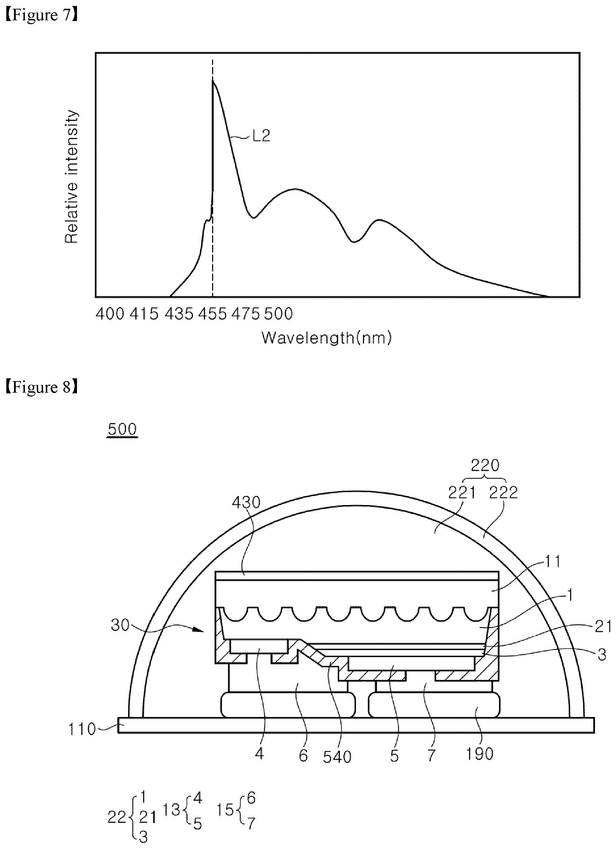

FIG. 6 is an exemplary view of a light emitting package according to a fourth embodiment of the present invention. In addition, FIG. 7 is a view of one example of a light spectrum of the light emitting package according to the fourth embodiment of the present invention.

The light emitting package 400 according to the fourth embodiment may include a light emitting device 20, a support substrate 110, a molding portion 220, and a first filter 430.

Referring to FIG. 6, the light emitting device 20, the support substrate 110 and the molding portion 220 of the light emitting package 400 according to the fourth embodiment are the same as the light emitting device 10, the support substrate 110 and the molding portion 220 of the light emitting package 200 according to the second embodiment shown in FIG. 4. In addition, the molding portion 220 of the light emitting package 400 according to this embodiment may have the same structure as the molding portion 120 of the light emitting package 100 according to the first embodiment shown in FIG. 2 or the molding portion 320 of the light emitting package 300 according to the third embodiment shown in FIG. 5.

The light emitting device 20 according to this embodiment may include a light generation layer 22 which is different from the light generation layer 12 of the light emitting device 10 shown in FIG. 4. More specifically, the configuration of an active layer 21 according to this embodiment may be different from the configuration of the active layer of the light emitting device 10 shown in FIG. 1 and FIG. 4. The active layer 21 according to this embodiment may have an indium content of less than 14% or an indium content of 14% or more. In addition, the active layer 21 may be formed of any nitride-based material capable of emitting blue light.

According to the fourth embodiment, the first filter 430 may cover at least part of a light emission surface of the light emitting device 20. For example, the first filter 430 may be disposed on the light emitting device 20. Here, the top of the light emitting device 20 faces in an opposite direction to the support substrate 110.

The first filter 430 may block light in a specific wavelength band among light generated in the light emitting device 20 from being emitted from the light emitting device 20 or may reduce the quantity of light in the specific wavelength band. The first filter 430 may be a filter that blocks light in the specific wavelength band. Alternatively, the first filter 430 may be a filter that absorbs light in the specific wavelength band.

The first filter 430 may be formed of an insulating material. For example, the insulating material forming the first filter 430 may include SiO₂, TiO₂, Nb₂O₅, MgO₂, Al₂O₃, ZrN, ZrO₂, AlN, and the like. The first filter 430 may be composed of a single layer or multiple layers of the insulating material. Alternatively, the first filter 430 may be formed by repeatedly stacking groups composed of a plurality of layers. The first filter 430 may adjust a transmitted or reflected wavelength band and the transmittance or cutoff rate by adjusting the thickness of each layer and the number of repeatedly stacked groups.

For example, the first filter 430 may be a distributed Bragg reflector (DBR) capable of transmitting light in the saturation enhancement band while reflecting light in the desaturation band.

According to this embodiment, the light emitting device 20 may emit light through upper and side surfaces thereof. Alternatively, the light emitting device 20 may emit light through a lower surface thereof. That is, according to this embodiment, light emission surfaces of the light emitting device 20 include an upper surface of the growth substrate 11, a side surface of the growth substrate 11, a side surface of the light generation layer 22, and a lower surface of the light generation layer 22. Here, the upper surface of the growth substrate 11 is an opposite surface to one surface of the growth substrate facing the light generation layer 22. In addition, the lower surface of the light generation layer 22 is one surface of the light generation layer 22 facing the support substrate 110.

Light emitted from the lower surface of the light emitting device 20 may be reflected by the support substrate 110 to be emitted toward the side surface or upper surface of the light emitting package 400. Alternatively, light emitted from the lower surface of the light emitting device 20 may be reflected by the support substrate 110 to be emitted from the side surface or upper surface of the light emitting device 20 after re-entering the light emitting device 20.

Here, among light emitted from the upper surface of the light emitting device 20, the first filter 430 allows most of light having a wavelength of 455 nm or more, that is, in the saturation enhancement band, to pass therethrough while completely or mostly blocking light in the wavelength band of 400 nm to less than 455 nm, which corresponds to the desaturation band.

Accordingly, the light emitting package 400 according to this embodiment may emit white light L2, in which the quantity of light in the saturation enhancement band is increased and the quantity of light in the desaturation band is decreased, as in the spectrum of the white light L2 shown in FIG. 7.

In addition, referring to FIG. 7, it can be seen that, in the wavelength band of 400 nm to 500 nm, the light emitting package 400 according to this embodiment has a smaller spectral area of light in the wavelength band of 400 nm to less than 455 nm, that is, in the desaturation band, than in the wavelength band of 455 nm to 500 nm, which corresponds to the saturation enhancement band. That is, the light emitting package 400 according to this embodiment may emit a greater quantity of light in the saturation enhancement band by the first filter 430 than in the desaturation band. Accordingly, it can be seen that, in the wavelength band of 400 nm to 500 nm, the light emitting package 400 according to this embodiment has a larger spectral area of light in the wavelength band of 455 nm to 500 nm, that is, in the saturation enhancement band, than in the wavelength band of 400 nm to less than 455 nm, which corresponds to the desaturation band.

That is, the spectral area of light in the saturation enhancement band (455 nm or more) emitted from the light emitting package may be 50% or more of a spectral area of light in the wavelength band of 400 nm to 500 nm.

The spectral area of light in the saturation enhancement band (455 nm or more) may be 65% or more of the spectral area of light in the wavelength band of 400 nm to 500 nm.

The spectral area of light in the saturation enhancement band (455 nm or more) may be 80% or more of the spectral area of light in the wavelength band of 400 nm to 500 nm.

FIG. 8 is an exemplary view of a light emitting package according to a fifth embodiment of the present invention.

Referring to FIG. 8, the light emitting package 500 according to the fifth embodiment may include a light emitting device 30 including a second filter 540, a support substrate 110, a molding portion 220, and a first filter 430.

The support substrate 110, the molding portion 220 and the first filter 430 of the light emitting package 500 according to the fifth embodiment are the same as the support substrate 110, the molding portion 220 and the first filter 430 of the light emitting package 400 according to the fourth embodiment shown in FIG. 6.

The light emitting device 30 according to this embodiment may include a growth substrate 11, a light generation layer 22, an electrode 13, an electrode pad 15, and a second filter 540. The growth substrate 11, the light generation layer 22, the electrode 13 and the electrode pad 15 according to this embodiment are the same as the growth substrate 11, the light generation layer 22, the electrode 13 and the electrode pad 15 of the light emitting device 20 (see FIG. 6) according to the fourth embodiment.

According to the fifth embodiment, the second filter 540 may be formed between the first filter 430 and the support substrate 110. In this case, the second filter 540 may be a part of the light emitting device 30.

The second filter 540 may be formed after formation of the electrode 13. Referring to FIG. 8, the second filter 540 may be formed below the growth substrate 11. In addition, the second filter 540 may be formed under the electrode 13 and the light generation layer 22. Here, the structure in which the second filter 540 is disposed below the growth substrate 11, the electrode 13 and the light generation layer 22 is shown with reference to FIG. 8. Accordingly, if the arrangement direction of the light emitting device 30 is changed, an arrangement position of the second filter 540 can also be changed. For example, when the light emitting device 30 is disposed such that the growth substrate 11 faces the support substrate 110, the second filter 540 may be formed on the electrode 13 and the light generation layer 22.

The second filter 540 may cover the lower and side surfaces of the light generation layer 22. In addition, the second filter 540 may cover some part of the upper surfaces of the first electrode 4 and the second electrode 5 and the side surfaces thereof.

Among light generated from the light emitting device 30, the second filter 540 may block light in a specific wavelength band from being emitted from the light emitting device 30 or may reduce the quantity of light in the specific wavelength band. The second filter 540 may be a filter that blocks light in a specific wavelength band. Alternatively, the second filter 540 may be a filter that absorbs light in a specific wavelength band.

For example, among light emitted from the side and lower surfaces of the light emitting device 30, the second filter 540 allows light having a wavelength of 455 nm or more, that is, in the saturation enhancement band, to pass therethrough while completely or mostly blocking light in the wavelength band of 400 nm to less than 455 nm, which corresponds to the desaturation band.

The second filter 540 may be formed of an insulating material. For example, the insulating material forming the second filter 540 may include SiO₂, TiO₂, Nb₂O₅, MgO₂, Al₂O₃, ZrN, ZrO₂, AlN, and the like. The second filter 540 may be composed of a single layer or multiple layers of the insulating material. Alternatively, the second filter 540 may be formed by repeatedly stacking groups composed of a plurality of layers. The second filter 540 may adjust a transmitted or reflected wavelength band and the transmittance or cutoff rate by adjusting the thickness of each layer and the number of repeatedly stacked groups.

For example, the second filter 540 may be a distributed Bragg reflector (DBR) capable of transmitting light in the saturation enhancement band while reflecting light in the desaturation band.

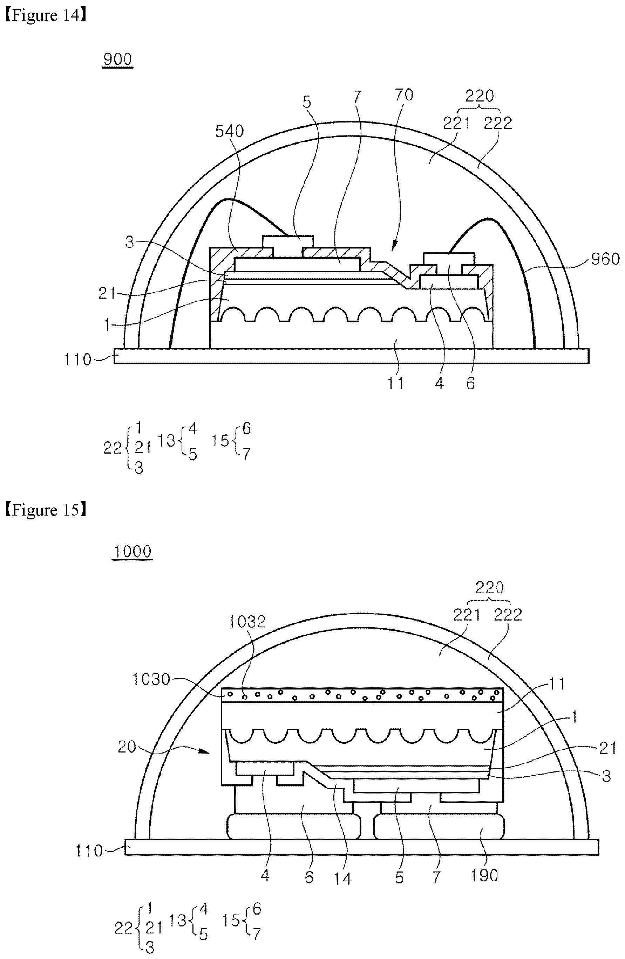

According to this embodiment, since the second filter 540 is formed of an insulating material, the light emitting device 30 may omit the insulating layer 14 of the light emitting device 10 according to the first embodiment shown in FIG. 1. That is, the second filter 540 may also act as the insulating layer 14 (see FIG. 14) of the first embodiment. However, the insulating layer may be further formed on a lower surface of the second filter 540 or on upper and lower surfaces of the second filter 540, as needed.

According to one embodiment, both the first filter 430 and the second filter 540 may be filters that reflect light in the desaturation band to prevent the light from being emitted from the light emitting device 30. The first filter 430 may reflect the light in the desaturation band on the upper surface of the light emitting device 30 and the second filter 540 may reflect light in the desaturation band on the side and lower surfaces of the light emitting device 30. In this case, the light in the desaturation band cannot escape from the light emitting device 30 and can be extinguished through repeated reflection by the first filter 430 and the second filter 540.

According to another embodiment, both the first filter 430 and the second filter 540 may be filters that absorb light in the desaturation band. Light in the desaturation band emitted from the upper surface of the light emitting device 30 may be absorbed by the first filter 430 and light in the desaturation band emitted from the side and lower surfaces of the light emitting device 30 may be absorbed by the second filter 540.

According to a further embodiment, one of the first filter 430 and the second filter 540 may be a filter that reflects light in the desaturation band to block the light from being emitted from the light emitting device, and the other filter may be a filter that absorbs the light in the desaturation band. The light in the desaturation band may be reflected by one of the first filter 430 and the second filter 540 to reenter the light emitting device 30 and may be absorbed by the other filter.

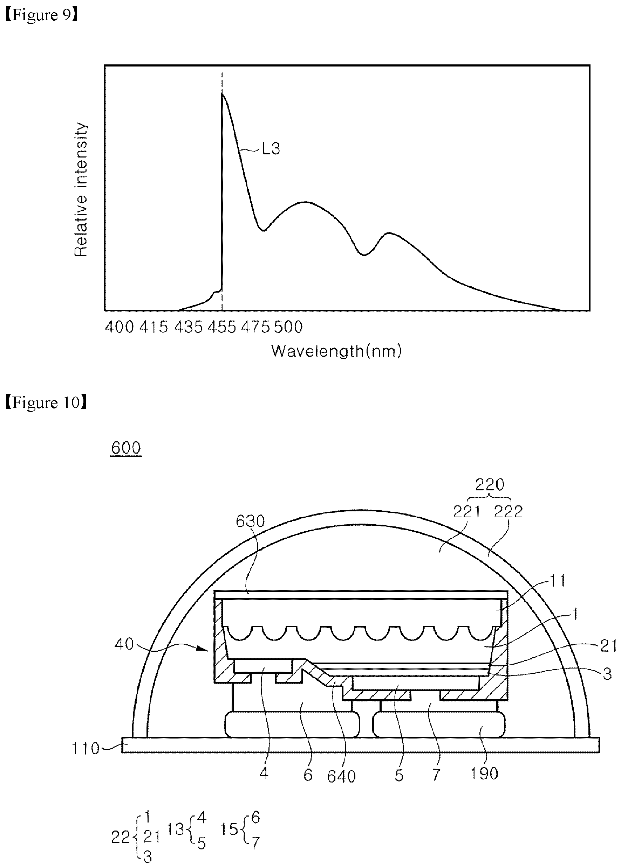

White light emitted from the light emitting package 500 including the first filter 430 and the second filter 540 according to this embodiment may have a light spectrum, as shown in FIG. 9.

FIG. 9 is a view of one example of the light spectrum of the light emitting package according to the fifth embodiment of the present invention.

Referring to FIG. 8, in the light emitting package 500 according to this embodiment, the first filter 430 and the second filter 540 cover the light emission surface of the light emitting device 30 excluding the side surface of the growth substrate 11. Accordingly, in the light emitting package 500, the first filter 430 and the second filter 540 may block at least some fraction of light in the desaturation band.

White light L3 emitted from the light emitting package 500 (see FIG. 8) according to this embodiment may have light spectrum characteristics, as shown in FIG. 9.

Referring to FIG. 9, it can be seen that, in the blue wavelength band of 400 nm to 500 nm, the light emitting package 500 (see FIG. 8) according to this embodiment has a much smaller spectral area of light in the wavelength band of 400 nm to less than 455 nm, that is, in the desaturation band, than in the other blue wavelength bands. That is, the light emitting package 500 (see FIG. 8) according to this embodiment may emit a smaller quantity of light in the desaturation band than in other blue wavelength bands by the first filter 430 and the second filter 540.

In addition, referring to FIG. 9, the white light L3 emitted from the light emitting package 500 (see FIG. 8) has a much lower ratio of light in the wavelength band of 400 nm to less than 455 nm, that is, in the desaturation band, than in the other wavelength bands.

Accordingly, the spectral area of light in the saturation enhancement band (455 nm or more) emitted from the light emitting package may be 50% or more of the spectral area of light in the wavelength band of 400 nm to 500 nm.

The spectral area of light in the saturation enhancement band (455 nm or more) may be 65% or more of the spectral area of light in the wavelength band of 400 nm to 500 nm.

The spectral area of light in the saturation enhancement band (455 nm or more) may be 80% or more of the spectral area of light in the wavelength band of 400 nm to 500 nm.

FIG. 10 to FIG. 12 are views of light emitting packages according to sixth to eighth embodiments of the present invention. The following description will focus on different features of the light emitting packages according to the sixth to eighth embodiment from those of the light emitting devices and the light emitting packages described above.

FIG. 10 is an exemplary view of the light emitting package according to the sixth embodiment of the present invention.

Referring to FIG. 10, the light emitting package 600 according to the sixth embodiment may include a light emitting device 40 including a second filter 640, a support substrate 110, a molding portion 220, and a first filter 630.

The support substrate 110 and the molding portion 220 of the light emitting package 600 according to the sixth embodiment are the same as the support substrate 110 and the molding portion 220 of the light emitting package 500 (see FIG. 8) according to the fifth embodiment.

The light emitting device 40 according to this embodiment may include a growth substrate 11, a light generation layer 22, an electrode 13, an electrode pad 15, and a second filter 640. The growth substrate 11, the light generation layer 22, the electrode 13 and the electrode pad 15 of the light emitting device 40 according to this embodiment are the same as the growth substrate 11, the light generation layer 22, the electrode 13 and the electrode pad 15 of the light emitting device 30 according to the fifth embodiment shown in FIG. 8, respectively.

According to this embodiment, the first filter 630 and the second filter 640 have the same features as the first filter 430 and the second filter 540 of the light emitting package 500 (see FIG. 8) according to the fifth embodiment excluding the structures thereof.

In this embodiment, the second filter 640 may cover a side surface of the growth substrate 11, a side surface of the light generation layer 22, a lower surface of the light generation layer 22, a side surface of the electrode 13, and a portion of a lower surface of the electrode 13.

In addition, the first filter 630 may cover the upper surface of the light emitting device 40. That is, the first filter 630 may cover the upper surface of the growth substrate 11. Here, the first filter 630 may further cover an upper surface of the second filter 640.

Alternatively, the first filter 630 may cover only the upper surface of the light emitting device 40. Alternatively, the first filter 630 may cover only the upper surface of the light emitting device 40 and the second filter 640 may cover a side surface of the first filter 630.

As such, in the light emitting package 600 according to this embodiment, the first filter 630 and the second filter 640 may cover the entire light emission surface of the light emitting device 40.

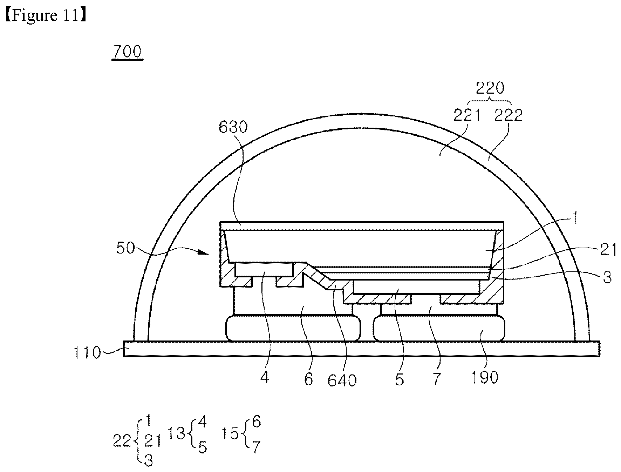

FIG. 11 is an exemplary view of the light emitting package according to the seventh embodiment of the present invention.

Referring to FIG. 11, the light emitting package 700 according to the seventh embodiment may include a light emitting device 50 including a second filter 640, a support substrate 110, a molding portion 220, and a first filter 630.

The support substrate 110 and the molding portion 220 of the light emitting package 700 according to the seventh embodiment are the same as the support substrate 110 and the molding portion 220 of the light emitting package 500 according to the fifth embodiment shown in FIG. 8.

The light emitting device 50 according to this embodiment may include a light generation layer 22, an electrode 13, an electrode pad 15, and a second filter 640. The light emitting device 50 according to this embodiment may have a structure in which the growth substrate is omitted, as shown in FIG. 11.

Accordingly, the second filter 640 may cover a side surface of the light generation layer 22, a lower surface of the light generation layer 22, a side surface of the electrode 13, and a portion of a lower surface of the electrode 13.

In addition, the first filter 630 may cover the upper surface of light emitting device 50. In this embodiment, since the growth substrate 11 is omitted, the first filter 630 may cover an upper surface of the light generation layer 22. In addition, the filter may further cover an upper surface of the second filter 640.

The structures of the first filter 630 and the second filter 640 according to this embodiment may be modified in various ways so long as the first filter and the second filter can cover the entire light emission surface of the light emitting device 50.

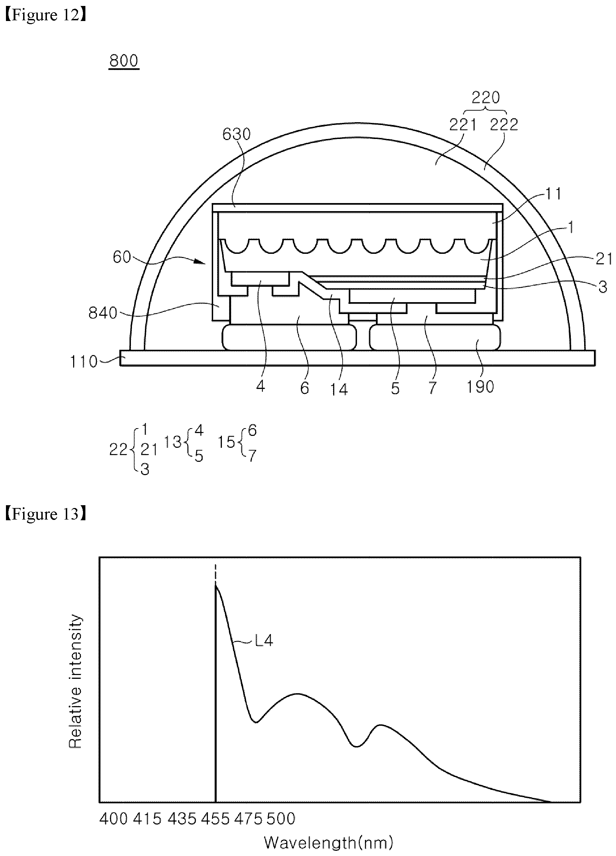

FIG. 12 is an exemplary view of the light emitting package according to the eighth embodiment of the present invention.

Referring to FIG. 12, the light emitting package 800 may include a light emitting device 60, a support substrate 110, a molding portion 220, a first filter 630, and a second filter 840.

The support substrate 110 and the molding portion 220 of the light emitting package 800 according to the eighth embodiment are the same as the support substrate 110 and the molding portion 220 of the light emitting package 500 according to the fifth embodiment shown in FIG. 8.

The light emitting device 60 according to this embodiment may include a growth substrate 11, a light generation layer 22, an electrode 13, an electrode pad 15, and an insulating layer 14. Here, the growth substrate 11, the light generation layer 22, the electrode 13 and the electrode pad 15 of the light emitting device 60 are the same as the growth substrate 11, the light generation layer 22, the electrode 13 and the electrode pad 15 of the light emitting package 500 according to the fifth embodiment shown in FIG. 8.

In addition, according to this embodiment, the insulating layer 14 may cover a side surface of the light generation layer 22, a lower surface of the light generation layer 22, a side surface of the electrode 13, and a portion of a lower surface of the electrode 13. The insulating layer 14 according to this embodiment is the same as the insulating layer 14 of the light emitting device 10 (see FIG. 1) according to the first embodiment.

In the light emitting package 800 according to this embodiment, the second filter 840 may cover a side surface of the growth substrate 11, the side surface of the light generation layer 22, the lower surface of the light generation layer 22, and a side surface of the electrode pad 15. In the above embodiment, the second filter 840 is formed inside the light emitting device 60 to constitute the light emitting device 60, whereas the second filter 840 according to this embodiment may be formed outside the light emitting device 60.

Accordingly, in this embodiment, the second filter 840 may be formed after completion of the process of forming the light emitting device 60 instead of being formed during the process of forming the light emitting device 60. That is, in this embodiment, after formation of the light emitting device 60, the second filter 840 may cover the light emission surface of the light emitting device 60 through a separate process.

The first filter 630 may cover the upper surface of the light emitting device 60. Here, the first filter 630 may further cover an upper surface of the second filter 840.

The structures of the first filter 630 and the second filter 840 according to this embodiment may be modified in various ways so long as the first filter and the second filter can cover the entire light emission surface of the light emitting device 60.

As such, in the light emitting packages 600, 700, 800 according to the sixth to eighth embodiments, the first filter 630 and the second filter 640; 840 may cover the entire light emission surface of the light emitting device 60.

Referring to FIG. 10 to FIG, 12 in the 2 light emitting packages 600, 700, 800, the first filter 630 and the second filter 640, 840 may block at least some fraction of light in the desaturation band.

Accordingly, in the light emitting packages 600, 700, 800 according to the sixth to eighth embodiments, since the first filter 630 and the second filter 640; 840 cover the entire light emission surface of the light emitting device, the white light may have light spectrum characteristics, as shown in FIG. 13.

FIG. 13 is a view of other examples of light spectra of the light emitting packages according to the sixth to eighth embodiments of the present invention.

Referring to the spectrum of white light L4 shown in FIG. 13, light in the wavelength band of 400 nm to less than 455 nm, that is, in the desaturation band, is blocked from being emitted by the first filter 630 (see FIG. 10 to FIG. 13) and the second filter 640; 840 see (FIG. 10 to FIG. 13).

In addition, the first filter 630 and the second filter 640; 840 may block some fraction of light in the desaturation band. In this case, the white light emitted from the light emitting packages 600, 700, 800 according to the sixth to eighth embodiments may have similar characteristics to the light spectrum having a low ratio of light in desaturation band, as shown in FIG. 9.

Accordingly, the spectral area of light in the saturation enhancement band (455 nm or more) emitted from the light emitting package may be adjusted to 50% or more of the spectral area of light in the wavelength band of 400 nm to 500 nm.

Alternatively, the spectral area of light in the saturation enhancement band (455 nm or more) may be adjusted to 65% or more of the spectral area of light in the wavelength band of 400 nm to 500 nm.

Preferably, the spectral area of light in the saturation enhancement band (455 nm or more) is adjusted to 80% or more of the spectral area of light in the wavelength band of 400 nm to 500 nm.

FIG. 14 is an exemplary view of a light emitting package according to a ninth embodiment of the present invention.

Referring to FIG. 14, the light emitting package 900 according to the ninth embodiment may include a light emitting device 70, a support substrate 110, a molding portion 220, and a second filter 540.

The support substrate 110 and the molding portion 220 of the light emitting package 900 according to the ninth embodiment are the same as the support substrate 110 and the molding portion 220 of the light emitting package 500 according to the fifth embodiment shown in FIG. 8.

The light emitting device 70 according to this embodiment may include the same configuration as the light emitting device 70 according to the fifth embodiment. That is, the growth substrate 11, the light generation layer 22, the electrode 13 and the second filter 540 of the light emitting device 70 according to this embodiment are the same as the growth substrate 11, the light generation layer 22, the electrode 13 and the second filter 540 of the light emitting device 30 (see FIG. 8) according to the fifth embodiment. In addition, comparing FIG. 8 with FIG. 14, there is no difference in function between the electrode 15 of the light emitting device 70 according to this embodiment and the electrode 15 of the light emitting device 30 (see FIG. 8) according to the fifth embodiment, despite structural differences therebetween.

However, the light emitting package 900 according to this embodiment is different from the light emitting packages according to the above embodiments in terms of arrangement of the light emitting device 70 and electrical connection to the support substrate 110.

In the light emitting device 70 according to this embodiment, the growth substrate 11 may be disposed to face downwards, and the electrode 13 and the electrode pad 15 may be disposed to face upwards. In FIG. 14, a lower portion is a direction toward the support substrate 110 and an upper portion is an opposite direction to the lower portion.

In this embodiment, the light emitting device 70 may be electrically connected to the support substrate 110 by wires 960 through wire bonding. The first electrode 4 of the light emitting device 70 and the second electrode 5 of the light emitting device 70 may be electrically connected to wires formed on the support substrate 110 by the wires 960, respectively. Here, although the growth substrate 11 adjoins the support substrate 110, the wires of the growth substrate 11 are insulated from the wires of the support substrate 110.

According to this embodiment, the second filter 540 may cover the upper and side surfaces of the light generation layer 22 while partially covering the upper surface of the electrode 13.

In another embodiment, the second filter 540 may further cover the side surface of the growth substrate 11.

FIG. 15 is an exemplary view of a light emitting package according to a tenth embodiment of the present invention.

Referring to FIG. 15, the light emitting package 1000 according to the tenth embodiment may include a light emitting device 20, a support substrate 110, a molding portion 220, and a first filter 1030.

The light emitting device 20, the support substrate 110 and the molding portion 220 of the light emitting package 1000 according to this embodiment are the same as the light emitting device 20, the support substrate 110 and the molding portion 220 of the light emitting package 600 according to the fourth embodiment shown in FIG. 6.

Here, in the light emitting package 1000 according to this embodiment, the first filter 1030 may cover an upper surface of the light emitting device 20.

According to this embodiment, the first filter 1030 may include a transparent resin and a light absorptive material 1032 dispersed in the transparent resin. For example, the transparent resin may include a silicone resin, an epoxy resin, an epoxy molding compound (EMC), and the like. In addition, the light absorptive material 1032 may include at least one selected from among Ca, C, SiO₂, and TiO₂. In addition, the light absorptive material 1032 is not limited thereto and may be selected from any material 1032 capable of absorbing light emitted from the light emitting device 20.

In the light emitting package 1000 according to this embodiment, the first filter 1030 including the light absorptive material 1032 may cover the upper surface of the light emitting device 20. Accordingly, at least some fraction of light emitted upwards from the light emitting device 20 may be absorbed by the first filter 1030.

Accordingly, the light emitting package 1000 according to this embodiment may reduce the quantity of blue light emitted from the light emitting device 20 through the first filter 1030. Thus, the quantity or ratio of light in the wavelength band of 455 nm or more, that is, in the saturation enhancement band, may be increased, whereas the quantity or ratio of light in the wavelength band of 400 nm to less than 455 nm, that is, in the desaturation band, may be decreased.

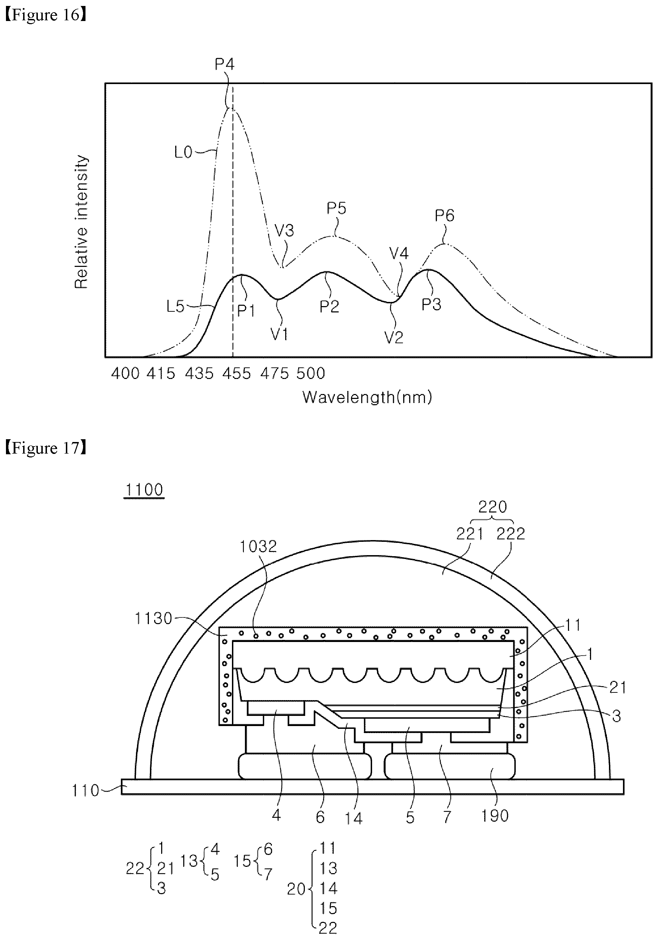

FIG. 16 is a view comparing a light spectrum of the light emitting package according to the tenth embodiment of the present invention with the spectrum of comparative white light.

Referring to FIG. 16, the light emitting package 1000 (see FIG. 15) according to the tenth embodiment emits white light L5 having a first peak wavelength P1 in the blue wavelength band, which is lower than the fourth peak wavelength P4 of the comparative white light L0. That is, the white light L5 according to this embodiment has a reduced quantity of light in the blue wavelength band, as compared to the comparative white light L0. Accordingly, in the white light L5 according to this embodiment, the spectral area of light in the desaturation band is reduced, as compared to the spectral area of the comparative white light L0 in the desaturation band. Accordingly, the light emitting package 1000 (see FIG. 15) according to the tenth embodiment may emit light in which the quantity or ratio of light in the saturation enhancement band is increased and the quantity or ratio of light in the desaturation band is reduced.

In addition, it can be seen that, in the blue wavelength band of 400 nm to 500 nm of the white light L5 emitted from the light emitting package 1000 (see FIG. 15) according to this embodiment, the spectral area of light in the wavelength band of 400 nm to less than 455 nm, that is, in the desaturation band, is much smaller than the spectral area of light in the wavelength band of 455 nm or more, which corresponds to the saturation enhancement band. That is, the light emitting package 1000 (see FIG. 15) according to this embodiment may emit light through the first filter 1030 (see FIG. 15) such that the quantity or ratio of the light in the wavelength band of 455 nm or more, that is, in the saturation enhancement band, is higher than the quantity or ratio of the light in the desaturation band. Accordingly, the spectral area of light in the saturation enhancement band (455 nm or more) emitted from the light emitting package may be adjusted to 50% or more of the spectral area of light in the wavelength band of 400 nm to 500 nm. Alternatively, the spectral area of light in the saturation enhancement band (455 nm or more) may be adjusted to 65% or more of spectral area of light in the wavelength band of 400 nm to 500 nm. Alternatively, the spectral area of light in the saturation enhancement band (455 nm or more) may be adjusted to 80% or more of the spectral area of light in the wavelength band of 400 nm to 500 nm.

In addition, comparing the white light L5 according to this embodiment with the comparative white light L0, a difference in intensity between the second peak wavelength P2 and the fifth peak wavelength P5 is not large and a difference in intensity between the third peak wavelength P3 and the sixth peak wavelength P6 is not large. In addition, a difference in intensity between the first valley wavelength V1 and the third valley wavelength V3 is not large and the second valley wavelength V2 and the fourth valley wavelength V4 have similar intensity.

That is, the quantity of light in the blue wavelength band of the white light L5 according to this embodiment is lower than the quantity of light in the blue wavelength band of the comparative white light L0, and the intensity and quantity of light in other wavelength bands thereof are similar to the intensity and quantity of light in other wavelength bands of the comparative white light L0.

As such, in the green wavelength band and the red wavelength band, the white light L5 according to this embodiment has a similar spectrum to the comparative white light L0. That is, the quantity of green light emitted from the green phosphor in the light emitting package 1000 (see FIG. 15) according to the tenth embodiment and the quantity of red light emitted from the red phosphor therein are similar to the quantity of the comparative white light L0. Thus, the white light L5 according to this embodiment can maintain color saturation.

FIG. 17 is an exemplary view of a light emitting package according to an eleventh embodiment of the present invention.

Referring to FIG. 17, the light emitting package 1100 according to the eleventh embodiment of the present invention may include a light emitting device 20, a support substrate 110, a molding portion 220, and a first filter 1130.

The light emitting package 1100 according to this embodiment has the same structure as the light emitting package 1000 (see FIG. 15) according to the tenth embodiment excluding the structure of the first filter 1130.

In the light emitting package 1100 according to this embodiment, the first filter 1130 may cover upper and side surfaces of the light emitting device 20.

Referring to FIG. 15 and FIG. 17, in the light emitting package 1000 according to the tenth embodiment and the light emitting package 1100 according to the eleventh embodiment, the first filter 1030; 1130 each including a light absorptive material 1032 may cover at least part of the light emission surface of the light emitting device 20.

In addition, the first filter 1030; 1130 may include the light absorptive material 1032. The light absorptive material 1032 may absorb at least some fraction of light emitted from the light emitting device 20. Accordingly, the light emitting package 1000; 1100 may reduce the quantity of the light emitting device 20 through the first filter 1030; 1130. That is, the light emitting package 1000; 1100 may reduce the quantity of blue emitted from the light emitting device 20.

As such, the light emitting package 1000; 1100 according to the tenth and eleventh embodiments may reduce the quantity of light in the desaturation band by reducing the quantity of blue light using the first filter 1030; 1130. Accordingly, the spectral area of light in the saturation enhancement band (455 nm or more) emitted from the light emitting package may be adjusted to 50% or more of the spectral area of light in the wavelength band of 400 nm to 500 nm. Alternatively, the spectral area of light in the saturation enhancement band (455 nm or more) may be adjusted to 65% or more of the spectral area of light in the wavelength band of 400 nm to 500 nm. Alternatively, the spectral area of light in the saturation enhancement band (455 nm or more) may be adjusted to 80% or more of the spectral area of light in the wavelength band of 400 nm to 500 nm.

The light emitting device 20 of each of the light emitting package 1000 according to the tenth embodiment shown in FIG. 16 and the light emitting package 1100 according to the eleventh embodiment shown in FIG. 17 may further include the second filter described in the above embodiments.

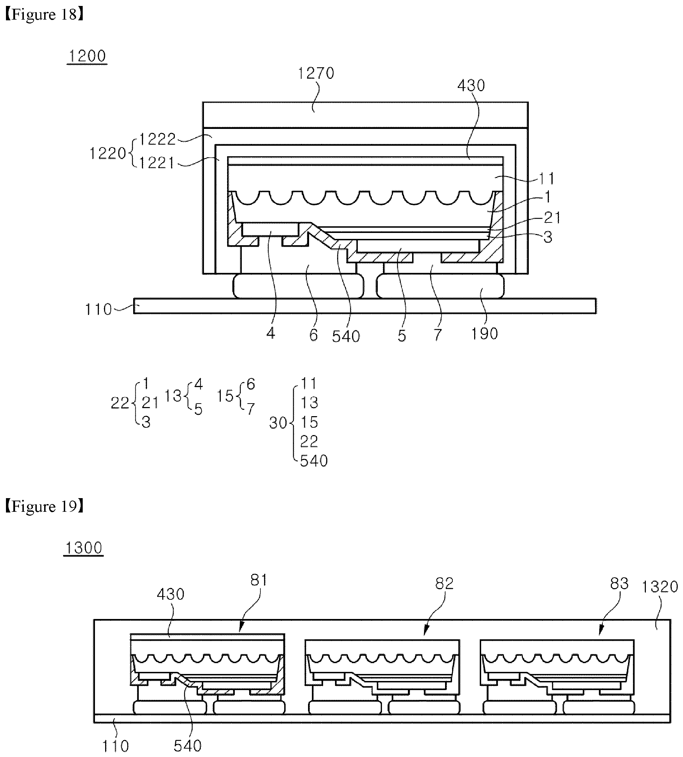

FIG. 18 is an exemplary view of a light emitting package according to a twelfth embodiment of the present invention.

Referring to FIG. 18, the light emitting package 1200 according to the twelfth embodiment of the present invention may include a light emitting device 30 including a second filter 540, a support substrate 110, a molding portion 1220, a first filter 430, and a reflective portion 1270.

The light emitting device 30, the support substrate 110 and the first filter 430 of the light emitting package 1200 according to this embodiment are the same as the light emitting device 30, the support substrate 110 and the first filter 430 of the light emitting package 500 according to the fifth embodiment shown in FIG. 8. In addition, the structures and locations of the first filter 430 and the second filter 540 of the light emitting package 1200 according to this embodiment may be modified in various ways as in the above embodiments.

The molding portion 1220 according to this embodiment has the same features as the molding portions according to the above embodiment except for structural differences.

According to this embodiment, the molding portion 1220 may include a first molding portion 1221 and a second molding portion 1220. The first molding portion 1221 may cover upper and side surfaces of the light emitting device 30. In addition, the second molding portion 1220 may cover upper and side surfaces of the first molding portion 1221. The molding portions according to the above embodiments have a dome structure, whereas the first molding portion 1221 and the second molding portion 1220 according to this embodiment may have flat upper and side surfaces.

In addition, although the molding portion 1220 according to this embodiment has a bilayer structure, the molding portion 1220 may have a monolayer structure or a tri- or more layer structure, as described in the above embodiments.

According to this embodiment, the reflective portion 1270 may cover an upper surface of the molding portion 1220. Thus, the reflective portion 1270 may have a larger cross-sectional area than the upper surface of the light emitting device. However, it should be understood that the structure of the reflective portion 1270 is not limited thereto. Although FIG. 18 shows the reflective portion 1270 formed to cover the entire upper surface of the molding portion 1220, the molding portion 1220 may cover a portion of the upper surface thereof.

The reflective portion 1270 may be composed of a single layer or multiple layers. When the reflective portion 1270 is composed of multiple layers, all of the layers may have the same cross-sectional area or at least one layer may have a cross-sectional area different from the other layers.

According to this embodiment, the reflective portion 1270 may be a distributed Bragg reflector. Alternatively, the reflective portion 1270 may be formed of a metal reflecting light. Alternatively, the reflective portion 1270 may include at least one layer composed of the distributed Bragg reflector and the metal.

The reflective portion 1270 may reflect light emitted upwards from the light emitting device 30. The light reflected by the reflective portion 1270 may be emitted through a side surface of the molding portion 1220. Alternatively, the light reflected by the reflective portion 1270 may reenter the light emitting device 30.

Some fractions of light having reentered the light emitting device 30 may be repeatedly reflected by the first filter 430 and the second filter 540 to be extinguished, or may be absorbed by the first filter 430 and the second filter 540. In addition, other fractions of light having reentered the light emitting device 30 may pass through the first filter 430 and the second filter 540 to be emitted through the side surface of the molding portion 1220.

The light emitting device 30 generally emits a greater quantity of light in an upward direction than in a lateral direction.

Accordingly, the reflective portion 1270 according to this embodiment reflects at least some fraction of light emitted in the upward direction to be emitted through a side surface of the light emitting package 1200 such that the light emitting package 1200 uniformly emits light in all directions.

Alternatively, the reflective portion 1270 according to this embodiment may reflect all fractions of light emitted in the upward direction to be emitted only through the side surface of the light emitting package 1200.

As such, the light emitting package 1200 according to this embodiment can emit light uniformly in all directions or emit light only through the side surface thereof while increasing the ratio of light in the saturation enhancement band and decreasing the ratio of light in the desaturation band.

FIG. 19 is an exemplary view of a light emitting package according to a thirteenth embodiment of the present invention.

Referring to FIG. 19, the light emitting package 1300 according to the thirteenth embodiment may include a plurality of light emitting devices, a support substrate 110, a molding portion 1320, and a first filter 430.

According to this embodiment, the support substrate 110 has the same configuration as the support substrate 110 according to the above embodiments.

The light emitting package 1300 according to this embodiment may include first to third light emitting devices 81, 82, 83. The first light emitting device 81 may be a blue light emitting device emitting blue light, the second light emitting device 82 may be a green light emitting device emitting green light, and the third light emitting device 83 may be a red light emitting device emitting red light. The first light emitting device 81 may have the same structure as the light emitting device 30 shown in FIG. 8.

The first to third light emitting devices 81, 82, 83 may be disposed on the support substrate 110. In FIG. 19, the first to third light emitting devices 81, 82, 83 are arranged parallel to each other. However, the arrangement sequence and arrangement structure of the light emitting devices may be changed in various ways. In addition, the first to third light emitting devices 81, 82, and 83 may be connected in series or in parallel by wires formed on the support substrate 110.

According to this embodiment, the molding portion 1320 may be formed on the support substrate 110 to cover all of the first to third light emitting devices 81, 82, 83. The molding portion 1320 may be formed of a light transmissive material. For example, the molding portion 1320 may be formed of at least one selected from among an epoxy resin, a silicone resin, glass, and ceramics.

The light emitting package 1300 according to this embodiment may emit white light in which blue light, green light, and red light emitted from the first to third light emitting devices 81, 82, 83 are mixed. Accordingly, the molding portion 1320 may not include wavelength conversion materials for wavelength conversion of light into green light and red light.

In this embodiment, the molding portion 1320 covers all of the first to third light emitting devices 81, 82, 83. Alternatively, the molding portion 1320 may cover each of the first to third light emitting devices 81, 82, 83. Here, the molding portion 1320 covering the first light emitting device 81, the molding portion 1320 covering the second light emitting device 82, and the molding portion 1320 covering the third light emitting device 83 may be spaced apart from one another.

In this embodiment, the first filter 430 may be formed on the first light emitting device 81. In addition, the first light emitting device 81 may be formed with the second filter 540. The first filter 430 and the second filter 540 may be the same as the first filter 430 and the second filter 540 described in the above embodiments, respectively. The first filter 430 and the second filter 540 may be modified not only into the structure shown in FIG. 19, but also into various structures described in the above embodiments.

In this embodiment, the first filter 430 and the second filter 540 may prevent light in the desaturation band among blue light emitted from the first light emitting device 81 from being emitted therefrom. In addition, the first filter 430 and the second filter 540 may absorb or block some fraction of blue light emitted from the first light emitting device 81 to reduce the quantity of blue light emitted to the outside. As the quantity of blue light is decreased, the quantity of light in the desaturation band is also decreased. As such, the first filter 430 and the second filter 540 may block or reduce light in the desaturation band.

In addition, although the light emitting package 1300 according to this embodiment includes both the first filter 430 and the second filter 540, the light emitting package 1300 may include one of the first filter 430 and the second filter 540.

The light emitting package 1300 according to this embodiment may further include a first light emitting device 81 emitting blue light, a second light emitting device 82 emitting green light, and a third light emitting device 83 emitting red light, a light emitting device emitting yellow light.

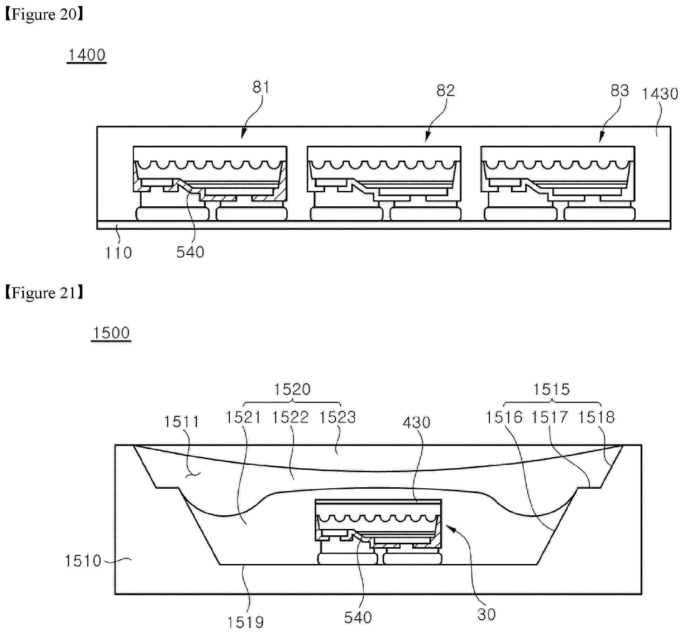

FIG. 20 is an exemplary view of a light emitting package according to a fourteenth embodiment of the present invention.

Referring to FIG. 20, the light emitting package 1400 according to the fourteenth embodiment may include a plurality of light emitting devices, a support substrate 110, and a first filter 1430.

In this embodiment, the light emitting package 1400 may include first to third light emitting devices 81, 82, 83. The first to third light emitting devices 81, 82, 83 are the same as the first to third light emitting devices 81, 82, 83 of the light emitting package 1300 according to the thirteenth embodiment shown in FIG. 19.

In addition, the support substrate 110 according to this embodiment is the same as the support substrate 110 of the light emitting package 1300 according to the thirteenth embodiment shown in FIG. 19.

According to this embodiment, the first filter 1430 may cover the first to third light emitting devices 81, 82, 83 disposed on the support substrate 110.

For example, the first filter 1430 may block light in the desaturation band among light emitted from the light emitting package 1400 or may reduce the quantity of light in the desaturation band among light emitted from the first to third light emitting devices 81, 82, 83.

The first filter 1430 may block light in the desaturation band or may reduce the quantity of light in the desaturation band among blue light emitted from the first light emitting device 81. In addition, green light emitted from the second light emitting device 82 and red light emitted from the third light emitting device 83 may also include light in the desaturation band. Here, the first filter 1430 may block light in the desaturation band or reduce the quantity of light in the desaturation band among green light emitted from the second light emitting device 82 and red light emitted from the third light emitting device 83.

In this embodiment, the first light emitting device 81 may include the second filter 540, whereas the second light emitting device 82 and the third light emitting device 83 may not include the second filter 540. However, it should be understood that the light emitting package 1400 according to this embodiment is not limited thereto. For example, each of the second light emitting device 82 and the third light emitting device 83 may further be formed with the second filter 540.

In another embodiment, the first filter 1430 may include a light absorptive material. Accordingly, the first filter 1430 may absorb some fraction of light emitted from the first to third light emitting devices 81, 82, 83. That is, the first filter 1430 may absorb some fraction of each of blue light, green light, and red light. Accordingly, the first filter 1430 may prevent serious imbalance with respect to green light and red light due to absorption or blocking of only blue light, thereby improving saturation through the light emitting package 1400.

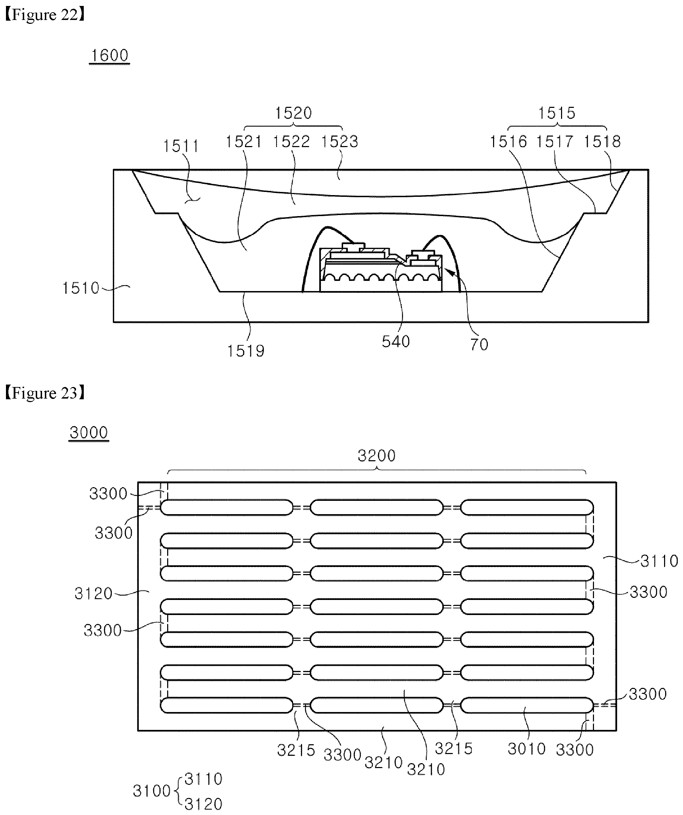

FIG. 21 is an exemplary view of a light emitting package according to a fifteenth embodiment of the present invention. In addition, FIG. 22 is an exemplary view of a light emitting package according to a sixteenth embodiment of the present invention.

Referring to FIG. 21 and FIG. 22, the light emitting package 1500; 1600 according to the fifteenth and sixteenth embodiments may include a housing 1510, a light emitting device 30; 70, and a molding portion 1520. Here, the molding portion 1520 may include a first molding portion 1521, a second molding portion 1522, and a third molding portion 1523.

Referring to FIG. 21 and FIG. 22, the housing 1510 may include a cavity 1511 open at an upper side thereof. The light emitting device 30; 70 is mounted in the cavity 1511 of the housing 1510. Further, in the light emitting package 1500 according to the fifteenth embodiment shown in FIG. 21, the first filter 430 may be disposed on the light emitting device 30 mounted in the cavity 1511 of the housing 1510.

The light emitting device 30 and the first filter 430 of the light emitting package 1500 according to the fifteenth embodiment shown in FIG. 21 are the same as the light emitting device 30 and the first filter 430 shown in FIG. 8. However, it should be understood that the light emitting package 1500 according to the fifteenth embodiment is not limited thereto. The light emitting device according to this embodiment may be any one of the aforementioned light emitting devices mounted on the support substrate by flip-chip bonding. In this embodiment, the light emitting package 1500 includes both the first filter 430 and the second filter 540. Alternatively, the light emitting package 1500 may include one of the first filter 430 and the second filter 540. In addition, the first filter 430 and the second filter 540 may be formed of various materials and may have various structures as in the above embodiments.

In addition, the light emitting device 70 of the light emitting package 1600 according to the sixteenth embodiment shown in FIG. 22 may have the same structure as the light emitting device 70 of the light emitting package 900 according to the ninth embodiment shown in FIG. 14. That is, the light emitting device 70 may include the second filter 540 and may be mounted on the support substrate by wire bonding.

An inner surface 1515 of the housing 1510 constituting the cavity 1511 may have an inclined surface. Alternatively, the inner surface 1515 of the housing 1510 may be formed to have a stepped cavity 1511, as shown in FIG. 21 and FIG. 22.

The inner surface 1515 of the housing 1510 may include a first inner surface 1516, a second inner surface 1517, and a third inner surface 1518. The first inner surface 1516 may be an inclined surface extending upwards from a bottom surface 1519 of the housing 1510 exposed through the cavity 1511. The third inner surface 1518 may be an inclined surface extending downwards from an upper surface of the housing 1510. Here, the first inner surface 1516 and the third inner surface 1518 may have the same slope. Alternatively, the first inner surface 1516 and the third inner surface 1518 may have different slopes. The second inner surface 1517 may be disposed between the first inner surface 1516 and the second inner surface 1517. In addition, the second inner surface 1517 may be parallel to a bottom surface 1519 or an upper surface of the housing 1510. Here, the second inner surface 1517 is connected at one end thereof to an upper end of the first inner surface 1516 and at the other end thereof to a lower end of the third inner surface 1518.

In this embodiment, the cavity 1511 of the housing 1510 may have a larger diameter at an upper portion thereof than at a lower portion thereof. However, the structure of the cavity 1511 of the housing 1510 is not limited thereto. The cavity 1511 of the housing 1510 may be formed such that the upper portion thereof has a larger diameter than the lower portion thereof.

In addition, the housing 1510 according to this embodiment may include wires electrically connected to the light emitting device 30; 70. The bottom surface 1519 of the housing 1510 exposed through the cavity 1511 may be formed with the wires. Accordingly, the light emitting device 30; 70 mounted on the cavity 1511 of the housing 1510 may be electrically connected to the wires on the bottom surface 1519 of the housing 1510. Referring to FIG. 21, the light emitting device 30 may be electrically connected to the wires on the bottom surface 1519 of the housing 1510 by flip-chip bonding. In addition, referring to FIG. 22, the light emitting device 70 may be electrically connected to the wire on the bottom surface 1519 of the housing 1510 by wire bonding.

In addition, the wires may be electrically connected to the wires on the bottom surface 1519 of the housing 1510 and may be exposed on at least one of an upper surface, an outer surface, and a lower surface of the housing 1510. Accordingly, the wires of the housing 1510 may electrically connect the light emitting device 30; 70 in the cavity 1511 to an external component outside the housing 1510.

The first molding portion 1521, the second molding portion 1522 and the third molding portion 1523 may be formed to fill the cavity 1511 of the housing 1510.

The first molding portion 1521 may cover the light emitting device 30; 70 while filling a lower space of the cavity 1511 constituted by the bottom surface 1519 of the housing 1510 and the first inner surface 1516. The first molding portion 1521 may be formed in an amount so as to completely cover the light emitting device 30; 70 instead of completely filling the lower space of the cavity 1511. However, the first molding portion 1521 may be formed such that an upper periphery of the first molding portion 1521 adjoins the upper end of the first inner surface 1516 or one end of the second inner surface 1517 by surface tension, as shown in FIG. 21 and FIG. 22.

In addition, the upper surface of the first molding portion 1521 may be a concavely or convexly curved surface instead of a flat surface. Some portion of the first molding portion 1521 placed on the light emitting device 30; 70 may have a convex surface and the other portion thereof may have a concave structure. The first molding portion 1521 having a curved upper surface can reduce total reflection of light on the upper surface thereof. Accordingly, the first molding portion 1521 having the curved upper surface can improve light extraction efficiency.

The second molding portion 1522 may cover the top of the first molding portion 1521. Here, the second molding portion 1522 may be formed to fill a lower space of the cavity 1511 and a portion of an upper space of the cavity 1511 disposed on the first molding portion 1521. Here, the upper space of the cavity 1511 is placed on the lower space of the cavity 1511 and is a space constituted by the second inner surface 1517 and the third inner surface 1518 of the housing 1510.

An upper periphery of the second molding portion 1522 may adjoin an upper end of the third inner surface 1518 by surface tension. In addition, the second molding portion 1522 may have a downwardly concave upper surface. The concave upper surface of the second molding portion 1522 may reduce total reflection of light. Accordingly, the second molding portion 1522 having the concave upper surface can improve light extraction efficiency.

The third molding portion 1523 may cover the top of the second molding portion 1522 while filling the upper space of the cavity 1511 on the second molding portion 1522. The third molding portion 1523 may be formed to have an upper surface coplanar with the upper surface of the housing 1510. Alternatively, the third molding portion 1523 may have an upwardly convex upper surface.

Each of the first to third molding portions 1521, 1522, 1523 may have at least two different thicknesses. For example, a portion of the first molding portion 1521 disposed on the light emitting device 30; 70 may have a different thickness than a portion thereof disposed between the light emitting device 30; 70 and the first inner surface 1516. A portion of the second molding portion 1522 disposed on the concave upper surface of the first molding portion 1521 may have a different thickness than a portion thereof disposed on the convex upper surface of the first molding portion 1521. In addition, the third molding portion 1523 may have a thickness gradually increasing from an outer surface thereof to the interior thereof.

At least one of the first to third molding portions 1521, 1522, 1523 may include a wavelength conversion material. Two of the first to third molding portions 1521, 1522, 1523 may include different wavelength conversion materials and one molding portion may not include a wavelength conversion material. For example, the wavelength conversion materials may include a red phosphor and a green phosphor. In addition, the first to third molding portions 1521, 1522, 1523 may include different wavelength conversion materials, respectively. For example, the wavelength conversion materials may include a red phosphor, a green phosphor, and a yellow phosphor. In addition, only one molding portion of the first to third molding portions 1521, 1522, 1523 may include a wavelength conversion material. For example, a red phosphor, a green phosphor, or a yellow phosphor may be dispersed in one molding portion. Alternatively, both the red phosphor and the green phosphor may be dispersed in one molding portion, or all of the red phosphor, the green phosphor and the yellow phosphor may be dispersed therein.

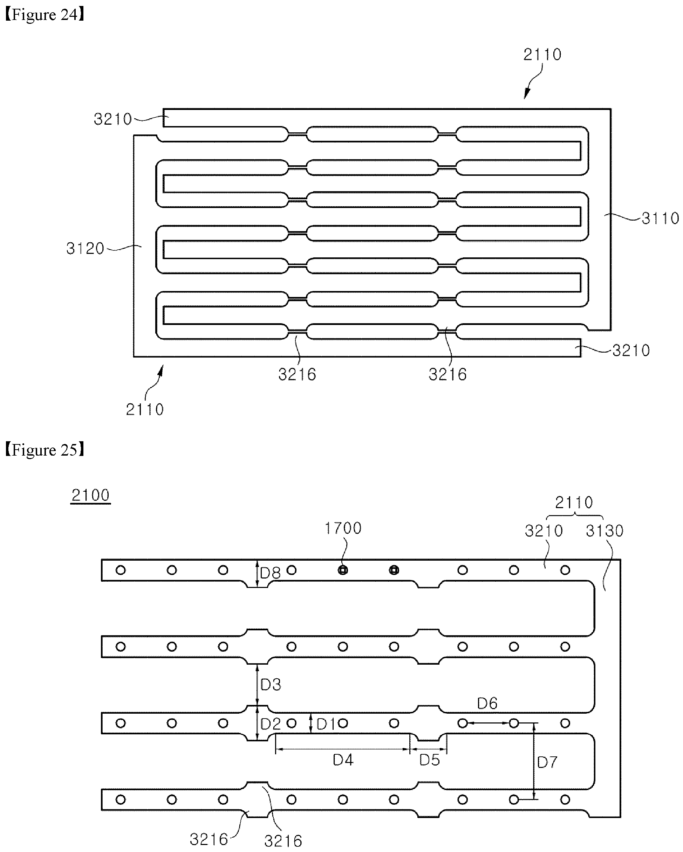

FIG. 23 to FIG. 25 are exemplary views of a backlight unit according to a first embodiment of the present invention. In addition, FIG. 23 and FIG. 24 show a method of manufacturing a support substrate and FIG. 25 shows the backlight unit according to the first embodiment of the present invention manufactured using the support substrate shown in FIG. 23 and FIG. 24.

The backlight unit 2100 (see FIG. 25) according to this embodiment may include a support substrate 2100 (see FIG. 25) and light emitting packages 1700 (see FIG. 25). In addition, the backlight unit 2100 may further include a reflective sheet, a cover, a light guide plate, a diffusion sheet, a prism sheet, and the like. The following description will mainly focus on the support substrate 2100 and the light emitting packages 1700 of the backlight unit 2100.

FIG. 23 is an exemplary view of a mother substrate for a backlight unit. FIG. 24 is an exemplary view illustrating a plurality of support substrates separated from the mother substrate according to the embodiment. In addition, FIG. 25 is an exemplary view of the backlight unit according to the first embodiment of the present invention.

A mother substrate 3000 is a substrate used for manufacturing the support substrate 2110 (see FIG. 24 and FIG. 25) of the backlight unit 2100 (see FIG. 25) according to this embodiment. A plurality of support substrates 2100 may be manufactured using the mother substrate 3000 according to this embodiment.

The mother substrate 3000 may have various circuit patterns of a conductive material on a base formed of an insulating material. Alternatively, the mother substrate 3000 may include a metal base, an insulating layer formed on upper and lower surfaces of the metal base, and a circuit pattern formed of a conductive material.

The mother substrate 3000 according to this embodiment is formed after formation of a plurality of holes 3010.

The mother substrate 3000 may include a mounting area 3200, a circuit area 3100, and a cutting area 3300. In addition, the mother substrate 3000 may have a plurality of holes 3010 therein.

Referring to FIG. 23, the plurality of holes 3010 may be arranged in columns and rows. The holes 3010 may have a long length and opposite side surfaces disposed in a longitudinal direction and having curved surfaces. In addition, both sides disposed between the opposite curved side surfaces may have long flat surfaces. Side surfaces of the mother substrate 3000 surrounding the plurality of holes 3010 may be exposed through a process of forming the holes 3010. Here, components constituting the mother substrate 3000 may be exposed through the plurality of holes 3010.

The mounting area 3200 is an area where the light emitting packages 1700 (see FIG. 25) are mounted. The mounting area 3200 may include a plurality of mounting sections 3210. Each of the mounting sections 3210 may be elongated in the longitudinal direction of the mother substrate 3000. The plurality of mounting sections 3210 may be arranged parallel to each other in the width direction of the mother substrate 3000. In addition, the mounting area 3200 may be divided into the plurality of mounting sections 3210 by a plurality of holes 3010 and a plurality of connecting portions 3215 disposed in the longitudinal direction of the mother substrate 3000. Here, the connecting portion 3215 refers to a portion in which the mounting sections 3210 are connected to each other on the mother board 3200. The connecting portion 3215 may be disposed between the holes 3010 arranged in series in the longitudinal direction of the mounting sections 3210.

In addition, the mounting sections 3210 may be formed with wires electrically connected to the light emitting packages 1700 (see FIG. 25) mounted on the mounting sections 3210. The wires formed on the mounting sections 3210 may connect the plurality of light emitting packages 1700 (see FIG. 25) on the mounting sections 3210 to each other in series or in parallel.

The circuit areas 3100 may include a plurality of circuit portions. The circuit areas 3100 may be disposed at opposite sides of the mounting area 3200. Each of the circuit areas 3100 disposed at the opposite sides of the mounting area 3200 may become a circuit portion. According to this embodiment, the mother substrate 3000 may include a first circuit portion 3110 and a second circuit portion 3120. The first circuit portion 3110 and the second circuit portion 3120 may be elongated along the width of the mother substrate 3000.

The first circuit portion 3110 and the second circuit portion 3120 may be connected to the plurality of mounting sections 3210. That is, the plurality of mounting sections 3210 may be connected at one side thereof to the first circuit portion 3110 and at the other side thereof to the second circuit portion 3120.

Each of the circuit areas 3100 may be formed with a control circuit to control operation of the light emitting packages 1700 (see FIG. 25) on the mounting sections 3210. In addition, the control circuits formed at the opposite sides of the mounting area 3200 may be electrically connected to the wires formed on at least one of the plurality of mounting sections 3210. That is, the plurality of mounting sections 3210 may be electrically connected to one of the first circuit portion 3110 and the second circuit portion 3120. Here, the plurality of mounting sections 3210 may be alternately connected to the first circuit portion 3110 and the second circuit portion 3120. For example, the first circuit portion 3110 may be electrically connected to oddnumbered mounting sections 3210 and the second circuit portion 3120 may be electrically connected to even-numbered mounting sections 3210.

The cutting areas 3300 are areas in which cutting is performed to separate the mother substrate 3000 into a plurality of substrates. In FIG. 23, the cutting areas 3300 are areas between two dotted lines facing each other. The cutting areas 3300 may be defined between the holes 3010 arranged in the longitudinal direction of the mother substrate 3000. That is, the cutting areas 3300 are formed between the mounting sections 3210 in the mounting area 3200.

In addition, the cutting areas 3300 may be formed in some portion between the circuit area 3100 and the mounting area 3200. For example, the cutting areas 3300 may be formed between the first circuit portion 3110 and the even-numbered mounting sections 3210. In addition, the cutting areas 3300 may be formed between the second circuit portion 3120 and the oddnumbered mounting sections 3210. That is, the cutting areas 3300 may be formed between the circuit portions 3110, 3120 and the mounting sections 3210, which are not electrically connected to each other.

Further, the cutting areas 3300 may be further formed at the other side of the first mounting section 3210 connected to the first circuit portion 3110 and at the other side of the last mounting section 3210 connected to the second circuit portion 3120 in the width direction. The cutting area 3300 may be formed from one side of the mother substrate 3000 in the longitudinal direction thereof to a hole 3010 adjacent thereto or to another cutting area 3300. Here, the other side of the first mounting section 3210 is disposed in the opposite direction to one side thereof connected to the first circuit portion 3110 to face the second circuit portion 3120. In addition, the other side of the last mounting section 3210 is disposed in the opposite direction to one side thereof connected to the second circuit portion 3120 to face the first circuit portion 3110.

Through the process of removing the cutting areas 3300 from the mother substrate 3000, two support substrates 2100 may be formed from the mother substrate 3000, as shown in FIG. 24. For example, the cutting areas 3300 may be removed by at least one of blade, laser, and plasma processing.

The support substrates 2110 may be separated from the mother substrate 3000 by removing the cutting areas 3300 at once through blade processing, laser processing, or plasma processing. Alternatively, the support substrates 2110 may be separated from the mother substrate 3000 by forming the holes 3010 in some portions of the cutting area 3300 or a groove in at least part of the cutting area 3300, followed by removing the remaining cutting areas 3300.

Although the cutting areas 3300 are removed from the mother substrate 3000 after formation of the plurality of holes 3010 on the mother substrate 3000 in this embodiment, formation of the holes 3010 may be performed simultaneously with removal of the cutting areas 3300.

The backlight unit 2100 according to this embodiment may include a support substrate 2100 and a plurality of light emitting packages 1700. The backlight unit 2100 shown in FIG. 25 may be formed by mounting the plurality of light emitting packages 1700 on the support substrate 2100 formed by the method described with reference to FIG. 23 and FIG. 24.

In this embodiment, the light emitting packages 1700 mounted on the support substrate 2100 may be any of the light emitting packages described above. Here, the light emitting packages 1700 according to this embodiment may be the light emitting packages according to the above embodiments, from which the support substrate is omitted. The support substrate of the backlight unit 2100 according to this embodiment may act as a support substrate for the light emitting packages from which the support substrate is omitted.

Referring to FIG. 25, the light emitting packages 1700 are arranged in a row on each of the mounting sections 3210 of the support substrate 2100. Alternatively, the light emitting packages 1700 may be arranged in a plurality of rows and columns. In addition, the backlight unit 2100 may further include an optical member disposed at least above the light emitting package 1700. The optical member disposed above the light emitting package 1700 may adjust the beam angle of light emitted from the light emitting package 1700 and protect the light emitting package 1700 from external impact and external impurities, such as dust. In addition, the optical member may be formed to surround not only an upper portion of the light emitting package 1700 but also a side surface thereof.

The support substrate 2100 of the backlight unit 2100 according to this embodiment may include a circuit portion 3130 and a plurality of mounting sections 3210. Each of the plurality of mounting sections 3210 may extend from one side of the circuit portion 3130 in a direction perpendicular to a longitudinal direction of the circuit portion 3130. Further, the plurality of mounting sections 3210 may be spaced apart from each other. That is, the plurality of mounting sections 3210 may be spaced apart from each other along a long side of the circuit portion 3130. The circuit portion 3130 shown in FIG. 25 corresponds to the first circuit portion 3110 or the second circuit portion 3120 shown in FIG. 23 and FIG. 24.

In addition, each of the mounting sections 3210 of the support substrate 2100 may further include a protrusion 3216. The protrusion 3216 may protrude from one side or both sides of a long length of the mounting section 3210. In addition, each of the mounting sections 3210 may include a plurality of protrusions 3216, which are spaced apart from each other to be arranged at constant intervals. Accordingly, each of the mounting sections 3210 has a structure in which a portion of one or both sides of the mounting section 3210 protrudes more outwards than other portions thereof due to the protrusions 3216.

Further, the protrusions 3216 formed on each of the mounting sections 3210 may be disposed to face the protrusions 3216 formed on another mounting section 3210 adjacent thereto. In addition, at least one of two mounting sections 3210 at opposite ends of the circuit portion 3130 in the longitudinal direction thereof may have the protrusion 3216 only on one side of the mounting section 3210 facing another mounting section 3210 adjacent thereto.

The protrusion 3216 may be formed by a difference in diameter between the hole 3010 of the mother substrate 3000 and the cutting area 3300. When the width of the cutting areas 3300 is smaller than the diameter of the holes 3010 of the mother substrate 3000, the protrusion 3216 may be formed after the cutting process. Here, the diameter of the hole 3010 is a distance between long sides of the hole 3010. In addition, the width of the cutting areas 3300 is a width in the same direction as the diameter, which is the distance between the long sides of the hole 3010. That is, the protrusions 3216 correspond to the connecting portions 3215 remaining after the cutting areas 3300 are removed from the mother substrate 3000.

According to this embodiment, the protrusions 3216 may have a structure including both sides each composed of a curved surface and planes each connecting both sides composed of the curved surfaces by the structure of the holes 3010 and the cutting areas 3300 formed on the mother substrate 3000. Such a structure of the protrusions 3216 can be easily formed by simply forming the cutting areas 3300 in a straight line on the mother substrate 3000.

According to this embodiment, the structure, number and location of the protrusions 3216 may be changed according to the structure, number and location of the holes 3010 formed in the mother substrate 3000 and the cutting areas 3300. In addition, the support substrate 2100 may omit the protrusions 3216 depending on the location of the cutting areas 3300 of the mother substrate 3000.

According to this embodiment, the support substrate 2100 may have a plurality of corners formed on the side surface of the mounting section 3210 by the protrusions 3216 and the circuit portion 3130. Some of the plurality of corners on the side surface of the mounting sections 3210 may be a curved surface having a radius of curvature. For example, the support substrate 2100 according to this embodiment may have a structure in which side surfaces of a connecting portion between the circuit portion 3130 and the mounting section 3210 and side surfaces of a portion formed with the protrusions 3216 have curved surfaces. For this structure, the holes 3010 on the mother substrate 3000 may have a structure in which both side surfaces disposed in the longitudinal direction of the mounting section 3210 have curved surfaces. As such, at least some corners formed inside the support substrate 2100 according to this embodiment may have curved surfaces.

When side surfaces of the support substrate 2100 constituting a corner among inner side surfaces of the support substrate 2100 are flat surfaces, some fraction of light cannot escape from a region adjacent to the corner even upon repeated reflection on the side surfaces constituting the corner. In addition, light can be repeatedly reflected in the region adjacent to the corner, causing light loss.

However, according to this embodiment, the side surfaces of the support substrate 2100 constituting an inner corner of the support substrate 2100 among the side surfaces thereof have curved surfaces. That is, the inner corner of the support substrate 2100 according to this embodiment has a curved surface. The corner having the curved surface according to this embodiment may provide a larger area near the corner than a corner having a flat surface. In addition, since the corner of the support substrate 2100 according to this embodiment has a curved surface, the angle and direction at which light is reflected may vary depending on the location where reflection of light occurs. Thus, the inner corner of the support substrate 2100 according to this embodiment has a curved surface, thereby increasing the region adjacent to the corner while inducing diffuse reflection. As such, at least part of the inner corner of the support substrate 2100 according to the present embodiment may have a curved surface, thereby minimizing light loss caused by repeated reflection of light in a region near the corner. The backlight unit 2100 according to this embodiment including the support substrate 2100 may have improved luminous efficacy.

According to this embodiment, the support substrate 2100 including the mounting sections 3210 each having a long length may be formed. Accordingly, light emitted from the plurality of light emitting packages 1700 on the support substrate 2100 may spread along the long side of the support substrate 2100.

According to one embodiment, when the mother substrate 3000 includes a metal base, one side or both sides of each of the mounting sections 3210 may be exposed to the outside by the process of forming the holes 3010 in the mother substrate 3000 and the process of cutting the cutting areas 3300. That is, the support substrate 2100 may have a structure in which one or both sides of the mounting section 3210 disposed between the light emitting packages 1700 are exposed to the outside. Here, the metal base may be exposed through the exposed side surfaces of the mounting sections 3210. Accordingly, light emitted from the light emitting packages 1700 may be reflected by the metal base exposed through the side surfaces of the support substrate 2100 to be diffused and scattered along the mounting sections 3210.

According to another embodiment, when the mother substrate 3000 includes an insulating base, a reflective layer may be formed on a side surface exposed from the inside of the support substrate 2100. The reflective layer may be formed on at least one of a side surface of the mounting section 3210 and a side surface of the protrusion 3216, as needed. For example, the reflective layer may be formed on the side surface of the mounting section 3210 of the support substrate 2100. Here, the reflective layer may be formed on the exposed side surface by the holes 3010 between the step of forming the holes 3010 in the mother substrate 3000 and the step of dicing the mother substrate 3000 into a plurality of support substrates 2100. Alternatively, the reflective layer may be formed on the protrusion 3216 of the support substrate 2100 or on the entire inner side surface of the support substrate 2100. Here, the reflective layer may be formed on the side surface of the protrusion 3216 and the entire inner side surface of the support substrate 2100 after separation of the mother substrate 3000 from the plurality of support substrates 2100. When the reflective layer is partially formed, the support substrate 2100 may have different reflectivity between a portion of the support substrate 2100 formed with the reflective layer and a portion of the support substrate 2100 not formed with the reflective layer. The reflective layer formed on the side surface exposed from the inside of the support substrate 2100 can prevent loss of light on the inner side surface of the support substrate 2100 when the light is emitted from the light emitting package 1700.

As such, the backlight unit 2100 according to this embodiment may have improved light uniformity through spreading and scattering of light along the side surface of the support substrate 2100.

Referring to FIG. 25, in the support substrate 2100 according to this embodiment, the mounting sections 3210 have a greater length D4 in the mounting area in which the light emitting packages 1700 are mounted is longer than length D5 of the protrusions 3216. However, the width of the mounting area in which the light emitting packages 1700 are mounted may be greater than widths D2, D8 of regions formed with the protrusions 3216. Accordingly, the protrusions 3216 having a large width are formed between the mounting areas in which the light emitting packages 1700 are mounted, thereby preventing the mounting sections 3210 having a long length from being bent or damaged. Accordingly, the mounting sections 3210 of the support substrate 2100 are prevented from being bent or damaged to damage the light emitting packages 1700 and the wires, thereby improving reliability of the backlight unit 2100.

Further, in the support substrate 2100 according to this embodiment, a distance D3 between the protrusions 3216 of the mounting sections 3210 adjacent to each other may be equal to or greater than widths D2, D8 of the protrusions 3216. Accordingly, the backlight unit 2100 according to this embodiment can sufficiently secure a separation distance between the protrusions 3216 to minimize interference of the protrusions 3216 with light reflected from the side surfaces of the support substrate 2100.

Further, in the support substrate 2100 according to this embodiment, a distance D7 between the light emitting packages 1700 mounted on the mounting sections 3210 adjacent to each other may be greater than a distance D6 between the light emitting packages 1700 mounted parallel to each other on the same mounting section 3210. The distance D7 between the light emitting packages 1700 mounted on the mounting sections 3210 adjacent to each other may be greater than the width D1 of the mounting area in which the light emitting packages 1700 are mounted. In addition, the distance D7 between the light emitting packages 1700 mounted on the mounting sections 3210 adjacent to each other may be greater than the distance D3 between the protrusions 3216 of the mounting sections 3210 adjacent to each other. As such, even when the distance between the mounting sections 3210 is large, the backlight unit 2100 according to this embodiment can maintain light uniformity by allowing light to spread along the long sides of the mounting sections 3210 and can prevent reduction in the quantity of light by minimizing light loss using the curved structure of the inner corner. Accordingly, the backlight unit 2100 according to this embodiment can reduce the number of light emitting packages 1700 to maintain a certain level of light quantity and light uniformity.

Although the light emitting packages 1700 are mounted on the support substrate 2100 in this embodiment, the light emitting devices including the second filter described in the above embodiments may be mounted thereon instead of the light emitting package. Alternatively, the light emitting devices including the first filter described in the above embodiment may be mounted on the support substrate 2100.

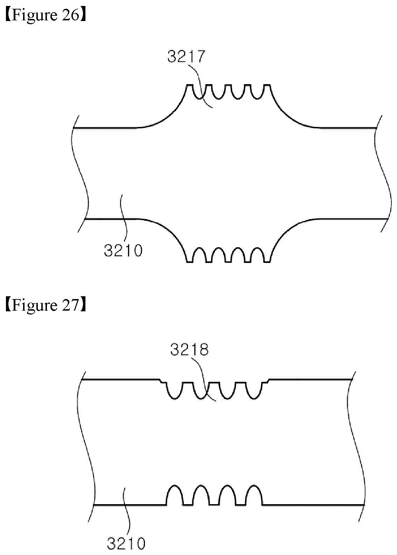

FIG. 26 is a view of another example of the connecting portion of the circuit board.

FIG. 27 is a view of a further embodiment of the connecting portion of the circuit board.

The connecting portions 3217, 3218 shown in FIG. 26 and FIG. 27 may be applied to the support substrate 2100 of the backlight unit 2100 shown in FIG. 23 to FIG. 25.

The support substrate 2100 (see FIG. 25) may include a connecting portion 3217; 3218, as shown in FIG. 26 or FIG. 27. The connecting portion 3217; 3218 may include a roughness structure on a portion from which the cutting area 3300 (see FIG. 23) is removed.

Referring to FIG. 26, the connecting portion 3217 may have an outwardly protruding structure.

Referring to FIG. 23, when both sides of the cutting area 3300 are placed collinear with both sides of the holes 3010 in the mother substrate 3000, the connecting portion 3218 may be formed, as shown in FIG. 27, instead of the connecting portion having the protruding structure. Here, both sides of the cutting area 3300 are parallel to both elongated sides of the holes 3010.

Referring to FIG. 26 and FIG. 27, the connecting portion 3217; 3218 may have a plurality of grooves concave towards the center of the mounting section 3210. However, it should be understood that the roughness structure of the connecting portion 3217; 3218 is not limited to the structure shown in FIG. 26 and FIG. 27. For example, the connecting portion 3217; 3218 may have a roughness structure including a plurality of convex structures in an outward direction of the mounting section 3210. In addition, the roughness structure of the connecting portion 3217; 3218 may be formed in a polygonal structure, such as a triangular shape, a rectangular shape, or the like. Further, the roughness structure of the connecting portion 3217; 3218 may be a regular structure, an irregular structure, or a combination thereof.

Such a structure of the connecting portion 3217; 3218 may be formed by a cutting device, which is used to cut the cutting areas 3300 (see FIG. 23) of the mother substrate 3000 (see FIG. 23). For example, when a cutting blade of the cutting device has a roughness structure, the connecting portion 3217; 3218 may be formed to have a roughness structure corresponding to the roughness structure of the cutting blade. In addition, the connecting portion 3217; 3218 may be formed by removing the cutting areas according to the structure of cutting areas designed in advance to have a roughness structure. As such, the roughness structure of the connecting portion 3217; 3218 may be formed in various ways.

According to these embodiments, the roughness structure of the connecting portion 3217; 3218 can induce diffuse reflection of light. Thus, light can be reflected in various directions by one surface of the connecting portion 3217; 3218 having the roughness structure thereon, thereby increasing light scattering while improving uniformity of light emitted from the backlight unit.

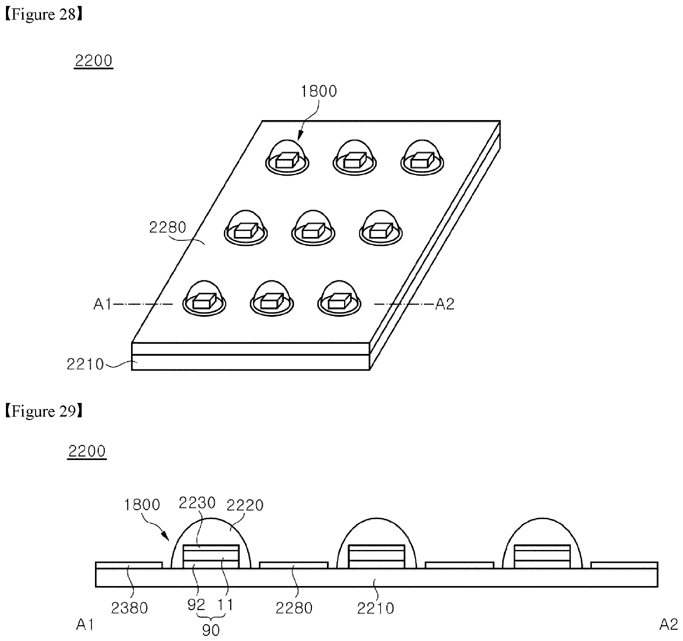

FIG. 28 and FIG. 29 are exemplary view of a backlight unit according to a second embodiment of the present invention.

FIG. 28 is a perspective view of the backlight unit 2200 according to the second embodiment and FIG. 29 is a cross-sectional view (A1-A2) of the backlight unit 2200 according to the second embodiment.

Referring to FIG. 28 and FIG. 29, the backlight unit 2200 according to the second embodiment may include a support substrate 2210, light emitting packages 1800, and a reflective sheet 2280.

The support substrate 2210 may include wires electrically connected to a plurality of light emitting packages 1800.

The plurality of light emitting packages 1800 may be mounted on the support substrate 2210. The plurality of light emitting packages 1800 may be arranged in at least one row and at least one column on the support substrate 2210. According to this embodiment, each of the light emitting packages 1800 may include a molding portion 2220 surrounding a light emitting device 90 and having a hemispherical structure. However, it should be understood that the structure of the light emitting package 1800 is not limited thereto and may be any one of the light emitting packages described above. Here, the light emitting package 1800 according to this embodiment may omit the support substrate of the light emitting packages described in the above embodiments. According to this embodiment, the support substrate of the backlight unit 2200 may act as the support substrate for the light emitting package. In addition, the interior structure of the light emitting device 90 is schematically shown in FIG. 28 and FIG. 29. The light emitting device 90 may also be any one of the light emitting devices described above. In addition, according to this embodiment, a filter 2230 may be formed on the light emitting device 90. The first filter 2230 may also be any one of the first filters described above. When the light emitting device 90 includes a second filter, the first filter 2230 may be omitted. This structure may also be applied to a support substrate, a light emitting device and a light emitting package according to the following embodiments.

The reflective sheet 2280 may cover an upper surface of the support substrate 2210. In addition, the reflective sheet 2280 may be formed with a plurality of holes. The holes of the reflective sheet 2280 may be provided with the light emitting packages 1800. That is, the light emitting packages 1800 may be disposed in the holes of the reflective sheet 2280 and electrically connected to the wire of the support substrate 2210 exposed through the holes of the reflective sheet 2280, respectively.

The reflective sheet 2280 may be formed of a light reflective material. In addition, the reflective sheet 2280 may reflect light emitted from the light emitting packages 1800 to be directed upwards.

Referring to FIG. 28, an inner surface of each of the holes of the reflective sheet 2280 is spaced apart from the molding portion 2220 of the light emitting package 1800. However, it should be understood that other implementations are possible. The reflective sheet 2280 may have an inner surface closely contacting the molding portion 2220 of the light emitting package 1800.

The reflective sheet 2280 may have a smaller thickness than the molding portion 2220. Here, the thickness of the reflective sheet 2280 is a length from an upper surface of the reflective sheet 2280 to a lower surface thereof. In addition, the thickness of the molding portion 2220 is a straight distance from a lower surface of the molding portion 2220 to an upper end thereof. Referring to FIG. 28, since all of the lower surfaces of the reflective sheet 2280 and the molding portion 2220 adjoin the upper surface of the support substrate 2210, the upper surface of the reflective sheet 2280 may be placed beneath the upper end of the molding portion 2220.

In addition, the thickness of the reflective sheet may be smaller than the thickness of a light generation layer 92 of the light emitting device 90 of the light emitting package 1800 or than the sum of the thicknesses of the light generation layer 92 and the growth substrate 11. Accordingly, the upper surface of the reflective sheet 2280 may be placed beneath the upper surface of the growth substrate 11 of the light emitting device 90 mounted on the support substrate 2210 by flip chip bonding. Alternatively, the upper surface of the reflective sheet 2280 may be placed beneath the upper surface of the light generation layer 92 of the light emitting device 90 mounted thereon by wire bonding. Here, the upper surface refers to a surface facing upwards. When the growth substrate 11 of the light emitting device 90 is omitted, the upper surface of the reflective sheet 2280 may be placed beneath the upper surface of the light generation layer 92 of the light emitting device 90 mounted on the support substrate 2210 by flip-chip bonding or wire bonding.

The reflective sheet 2280 may reflect some fraction of light emitted from a side surface of the light emitting package 1800 to be directed upwards. In addition, the reflective sheet 2280 may reflect light, which travels in a downward direction toward the upper surface of the reflective sheet 2280, to be directed upwards. That is, the reflective sheet 2280 according to this embodiment may reflect light, which is emitted from the light emitting package 1800 and travels toward the inner surface and the upper surface of the reflective sheet 2280, to be directed upwards.

Thus, the backlight unit 2200 according to this embodiment may allow light emitted from the side surface of the light emitting package 1800 to be emitted above a certain height of the light emitting package 1800 by the reflective sheet 2280. In addition, the backlight unit 2200 according to this embodiment may improve luminous efficacy by allowing the light emitted in the lateral direction to be directed towards a light guide plate or an optical sheet disposed at an upper portion thereof by the reflective sheet 2280.

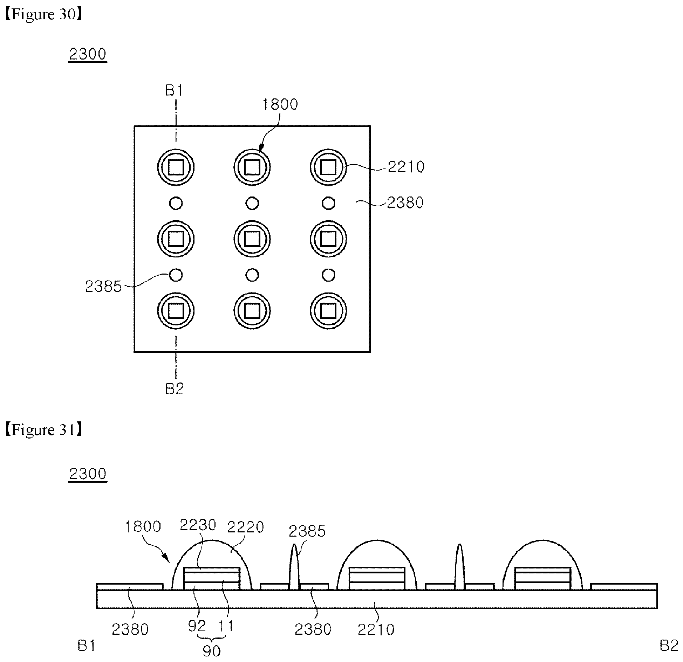

FIG. 30 and FIG. 31 are exemplary views of a backlight unit according to a third embodiment of the present invention.

FIG. 30 is a plan view of the backlight unit 2300 according to the third embodiment of the present invention and FIG. 31 is a cross-sectional view (B1-B2) of the backlight unit according to the third embodiment of the present invention

The backlight unit 2300 according to the third embodiment may have the same structure as the backlight unit 2300 according to the second embodiment excluding a reflective pillar 2385.

In this embodiment, a reflective sheet 2380 may be formed with holes in which the reflective pillars 2385 are disposed.

Referring to FIG. 31, a side surface of the reflective pillar 2385 closely contacts an inner surface of the reflective sheet 2380. Alternatively, the reflective pillar 2385 may be spaced apart from the inner surface of the reflective sheet 2380.

The reflective pillar 2385 may be disposed between light emitting packages 1800 on a support substrate 310. Referring to FIG. 30, each of the reflective pillars 2385 may be disposed between the light emitting packages 1800 on the same center line as a row of the plurality of light emitting packages 1800. However, it should be understood that arrangement of the reflective pillars 2385 is not limited thereto. Alternatively, each of the reflective pillars 2385 may be disposed between the light emitting packages 1800 on the same center line as a column of the plurality of light emitting packages 1800. Alternatively, each of the reflective pillars 2385 may be disposed between the light emitting packages 1800 arranged in columns and rows. As such, the plurality of reflective pillars 2385 may be regularly or irregularly arranged between the light emitting packages 1800.

The reflective pillars 2385 may be formed of a light reflective material. In addition, the reflective pillars 2385 may have a greater thickness than the molding portion 2220 of the light emitting package 1800. That is, an upper end of the reflective pillar 2385 may be placed above an upper end of the molding portion 2220. Accordingly, light emitted from the side surface of the light emitting package 1800 may collide with the reflective pillar 2385, which has a greater height than the molding portion 2220, to be reflected upwards.

In addition, the reflective pillars 2385 may have a width gradually decreasing from the bottom to the top thereof. Referring to FIG. 31, the reflective pillars 2385 may have a hemispherical structure. Since the reflective pillars 2385 have a width gradually decreasing upwards, the reflective pillars 2385 may reflect light upwards without being greatly affected by the location of the light emitting package 1800 or the traveling direction of light. In addition, the structure of the reflective pillars 2385 is not limited to a hemispherical structure having a curved surface. The reflective pillars 2385 may have any structure so long as the reflective pillars 2385 can reflect light upwards by the structure in which the width gradually decreases upwards.

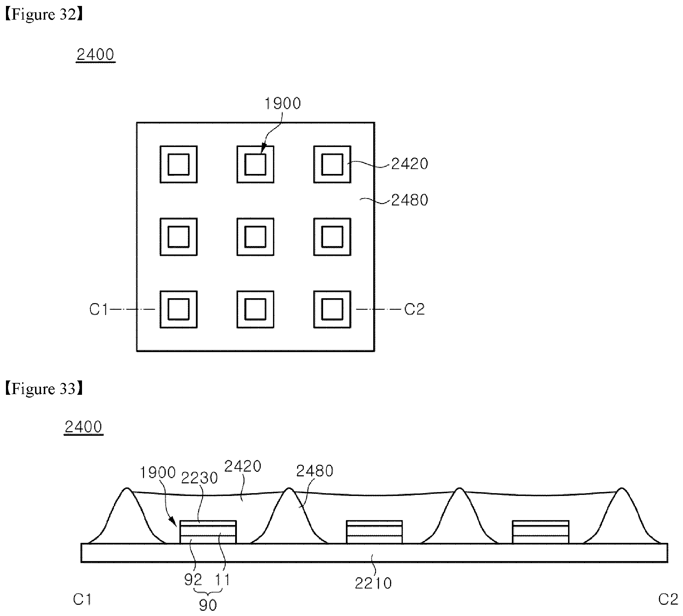

FIG. 32 and FIG. 33 are exemplary view of a backlight unit according to a fourth embodiment of the present invention.

FIG. 32 is a plan view of the backlight unit 2400 according to the fourth embodiment and FIG. 33 is a cross-sectional view (C1-C2) of the backlight unit 2400 according to the fourth embodiment.

The backlight unit 2400 according to the fourth embodiment may include a reflective sidewall 2480.

Referring to FIG. 32 and FIG. 33, each of the reflective sidewalls 2480 may be formed between the light emitting packages 1900 to surround the circumference of the light emitting packages 1900. That is, the reflective sidewalls 2480 may include openings exposing an upper surface of the support substrate 2210. In addition, the light emitting packages 1900 may be disposed on the upper surface of the support substrate 2210 exposed through the openings of the reflective sidewalls 2480.

The reflective sidewalls 2480 may be formed of a light reflective material. In addition, the reflective sidewalls 2480 may reflect light emitted from the side surface of the light emitting package 1900 to be directed upwards.

Referring to FIG. 33, the backlight unit 2400 according to this embodiment may include a molding portion 2420 that fills the openings of the reflective sidewalls 2480 to cover the light emitting packages 1900. Accordingly, the backlight unit 2400 according to this embodiment may include the molding portion 2420 filling the openings of the reflective sidewalls 2480 instead of the hemispherical molding portion covering the light emitting devices 90.

According to this embodiment, the molding portion 2420 filling the openings of the reflective sidewalls 2480 may have an upper periphery adjoining upper ends of the reflective sidewalls 2480. In addition, the molding portion 2420 may have a downwardly concave upper surface. Alternatively, the molding portion 2420 may have a flat upper surface or an upwardly convex upper surface.

The molding portion 2420 according to this embodiment may be formed of a transparent resin, such as an epoxy resin, a silicone resin, and the like. In addition, the molding portion 2420 may further include a wavelength conversion material, such as a phosphor or a quantum dot, which can convert a wavelength of light emitted from the light emitting device 90. The wavelength conversion material may be dispersed in the transparent resin of the molding portion 2420. The backlight unit 2400 according to this embodiment may emit white light in which light emitted from the light emitting device 90 is mixed with light wavelength converted by the phosphor.

Further, the backlight unit 2400 according to this embodiment may include plurality of light emitting devices 90 emitting different colors. The plurality of light emitting devices 90 emitting different colors may be disposed in the openings of the reflective sidewall 2480, respectively. For example, the backlight unit 2400 may emit white light by mixing light emitted from the plurality of light emitting devices 90. In this case, the molding portion 2420 may not contain the wavelength conversion material.

As such, the backlight unit 2400 according to this embodiment may emit white light through modification of the number and kinds of the light emitting devices 90 disposed in the openings of the reflective sidewalls 2480 and the kinds of phosphors dispersed in the molding portion 2420. Further, the molding portion 2420 may further include a light dispersion material. For example, the light dispersion material is a material, such as TiO₂, Ca, and the like, which can spread light in various directions by changing a refraction angle of light.

The backlight units 2100, 2200, 2300, 2400 described with reference to various embodiments of the present invention may include the support substrates 2110, 2210 and the light emitting packages 1800, 1900. In addition, the backlight units 2100, 2200, 2300, 2400 may further include a cover, a light guide plate, a diffusion sheet, a prism sheet, and the like.

Referring to FIG. 23 to FIG. 33, the light emitting packages in the backlight units according to the embodiments may omit the support substrate of the light emitting package described above. Here, the support substrate of the light emitting package refers to the support substrate 110 and the housing 1510. That is, when the support substrates 2110, 2210 of the backlight units act as the support substrate of the light emitting package, the support substrate may be omitted from the light emitting package. In other words, each of the support substrates 2110, 2210 of the backlight units may be directly electrically connected to the light emitting devices to supply current and voltage to the light emitting devices for operation of the light emitting devices.

In addition, each of the backlight units shown in FIG. 23 to FIG. 33 may further include the support substrate of the light emitting package. That is, the light emitting packages including the support substrate may be mounted on the support substrates 2110, 2210 of the backlight units. Here, the support substrate of the light emitting package may act as an interposer disposed between the support substrates 2110, 2210 of the backlight unit and the light emitting device to connect the support substrates 2110, 2210 to the light emitting device.

The light emitting devices, the light emitting packages and the backlight units according to various embodiments of the present invention may block light in the desaturation band or may reduce the quantity of light in the desaturation band. Accordingly, the light emitting devices, the light emitting packages and the backlight units according to the embodiments of the present invention may increase the quantity or ratio of light in the saturation enhancement band among light in the wavelength band of 400 nm to 500 nm in various ways while reducing the quantity or ratio of light in the desaturation band, thereby enabling emission of light with improved saturation through increase in quantity of light in the wavelength band excluding the desaturation band.

Although some embodiments have been described herein, it should be understood that these embodiments are provided for illustration only and are not to be construed in any way as limiting the present disclosure. Therefore, the scope of the present disclosure should be defined by the appended claims and equivalents thereto.

## Claims

1. A light emitting device comprising:
a light generation layer comprising a first semiconductor layer, a second semiconductor layer, and an active layer formed between the first semiconductor layer and the second semiconductor layer; and
an electrode comprising a first electrode electrically connected to the first semiconductor layer and a second electrode electrically connected to the second semiconductor layer,
wherein a spectral area of light in a saturation enhancement band of 455 nm or more among light emitted from the light emitting device is 50% or more of a spectral area of light in a wavelength band of 400 nm to 500 nm.

2. The light emitting device according to claim 1, wherein the light has a peak wavelength of 450 nm or more.

3. The light emitting device according to claim 2, wherein the active layer has an indium content of 14% or more.

4. The light emitting device according to claim 1, wherein the light emitted from the light emitting device have a first peak wavelength and a second peak wavelength, and a difference between the first peak wavelength and the second peak wavelength is 50nm to 100nm.

5. The light emitting device according to claim 4, wherein the light emitted from the light emitting device have a first peak wavelength having a full width at half maximum less than 20nm.

6. The light emitting device according to claim 1, wherein the light emitted from the light emitting device have a first peak wavelength in range of 450nm to 500nm and a second peak wavelength in range of 500nm to 580nm, and a third peak wavelength in range of 600nm to 680nm.

7. A light emitting package comprising:
a support substrate;
a light emitting device disposed on the support substrate to be electrically connected to the support substrate; and
a molding portion formed on the support substrate to cover the light emitting device and formed of a light transmissive material,
wherein the light emitting device comprises a first light emitting device comprising a light generation layer emitting light and an electrode;
the light generation layer comprises a first semiconductor layer, a second semiconductor layer, and an active layer formed between the first semiconductor layer and the second semiconductor layer;
the electrode comprises a first electrode electrically connected to the first semiconductor layer and a second electrode electrically connected to the second semiconductor layer;
the first light emitting device has a desaturation band in the range of 400 nm to less than 455 nm, and a light emitted from the molding portion has a smaller spectral area of light in a desaturation band than in other wavelength bands in 400nm to 500nm wavelength bands.

8. The light emitting package according to claim 7, wherein a spectral area of light in a wavelength band excluding the desaturation band is 50% or more of a spectral area of light of 400nm to 500nm wavelength band.

9. The light emitting package according to claim 7, wherein a spectral area of light in the desaturation band is less of 50% of a spectral area of light of 400nm to 500nm wavelength band.

10. The light emitting device according to claim 7, wherein the light has a peak wavelength of 450 nm or more.

11. The light emitting device according to claim 10, wherein the active layer has an indium content of 14% or more.

12. The light emitting device according to claim 7, wherein the light emitted from the light emitting device have a first peak wavelength and a second peak wavelength, and a difference between the first peak wavelength and the second peak wavelength is 50nm to 100nm.

13. The light emitting device according to claim 7, wherein the light emitted from the light emitting device have a first peak wavelength having a full width at half maximum less than 20nm.

14. A light emitting appratus comprising:
a support substrate;
a light emitting device disposed on the support substrate to be electrically connected to the support substrate; and
a molding portion formed on the support substrate to cover the light emitting device and formed of a light transmissive material,
wherein the light emitting device comprises a first light emitting device comprising a light generation layer emitting light in a blue wavelength band and an electrode electrically connected to the light generation layer;
the light generation layer comprises a first semiconductor layer, a second semiconductor layer, and an active layer formed between the first semiconductor layer and the second semiconductor layer;
the electrode comprises a first electrode electrically connected to the first semiconductor layer and a second electrode electrically connected to the second semiconductor layer;
the first light emitting device has a saturation enhancement band in the range of 455 nm or more, and a light emitted from the molding portion has a larger spectral area of light in a saturation enhancement band than in other wavelength bands in 400nm to 500nm wavelength bands.

15. The light emitting package according to claim 14, wherein a spectral area of light in a wavelength band of the saturation enhancement band is 50% or more of a spectral area of light of 400nm to 500nm wavelength band.

16. The light emitting package according to claim 14, wherein a spectral area of light in a wavelength band excluding the saturation enhancement band is less of 50% of a spectral area of light of 400nm to 500nm wavelength band.

17. The light emitting device according to claim 14, wherein the light has a peak wavelength of 450 nm or more.

18. The light emitting device according to claim 17, wherein the active layer has an indium content of 14% or more.

19. The light emitting device according to claim 14, wherein the light emitted from the light emitting device have a first peak wavelength and a second peak wavelength, and a difference between the first peak wavelength and the second peak wavelength is 50nm to 100nm.

20. The light emitting device according to claim 14, wherein the light emitted from the light emitting device have a first peak wavelength having a full width at half maximum less than 20nm.
